# EUROPEAN PATENT APPLICATION

(11) **EP 1 833 290 A1**
(43) Date of publication of application: **12.09.2007**
(21) Application number: 05811786.2
(22) Date of filing: 03.12.2005
(51) Int. Cl.: H05K 13/04, G06K 19/077, G06K 19/07, H05K 3/00, H05K 3/32

(54) **ELECTRONIC COMPONENT PRODUCTION METHOD AND ELECTRONIC COMPONENT PRODUCTION EQUIPMENT**

(30) Priority: 03.12.2004 JP 2004351258
(71) Applicant: Hallys Corporation, Akashi-shi Hyogo 6740064 (JP)
(72) Inventor: AOYAMA, Hiroshi, c/o HALLYS CORPORATION, Akashi-shi, Hyogo 6740064 (JP); NISHIGAWA, Ryoichi, c/o HALLYS CORPORATION, Akashi-shi, Hyogo 6740064 (JP)
(74) Representative: Kramer - Barske - Schmidtchen
(86) International application number: PCT/JP2005/022219
(87) International publication number: WO 2006/059731

(57) **Abstract**

A method for manufacturing an electronic component 5 in which an interposer 50 is bonded to a base circuit sheet includes a base circuit forming step of forming a base-side terminal in a continuous base member 610 in continuous sheet form, an arranging/bonding step of arranging the interposer 50 on a surface of the continuous base member 610 in which the base-side terminal is formed and bonding the interposer 50, and a separating step of cutting out the electronic component 5 from the continuous base member 610 to which the interposer 50 is bonded. In this electronic component manufacturing method, for the common continuous base member 610, each of the steps is repeated in parallel while the continuous base material 610 is being advanced.

## Description

### Technical Field

The present invention relates to a method for manufacturing an electronic component in which a sheet-like interposer, on which a semiconductor chip is mounted, is bonded to a sheet-like base circuit sheet and an apparatus for manufacturing an electronic component used in this manufacturing method.

### Background Art

For example, there have been available electronic components in which an interposer having a semiconductor chip mounted on a resin film is bonded to a surface of a sheet-like base circuit sheet formed from a resin film. Examples of such electronic components include an RF-ID medium in which an interposer having an IC chip mounted on a base circuit sheet is bonded to a base circuit sheet provided with an antenna pattern. In fabricating such an RF-ID medium, there is a case where, for example, an antenna sheet in individual-piece form provided with an antenna pattern is prepared beforehand and an interposer is bonded to the surface of this antenna sheet (refer to Patent Document 1, for example).

However, the above-described conventional method of manufacturing an electronic component has the following problem. That is, in the conventional method, the base circuit sheets in individual-piece form and the interposers are separately fabricated and finally the interposer is assembled on the base circuit sheet. Therefore, it is necessary to perform a base circuit sheet fabrication step, an interposer fabrication step, and an interposer bonding step independently of each other and hence there was a fear that the production efficiency of the electronic components could not be sufficiently improved.

Patent Document 1: Japanese Patent Laid-Open No. 2003-283120

### Disclosure of the Invention

The present invention was made in view of the above-described conventional problem and is intended to provide a method for manufacturing, with high production efficiency, an electronic component in which an interposer is used and an apparatus for manufacturing the electronic component used in this manufacturing method.

The first invention provides an electronic component manufacturing method for manufacturing an electronic component in which an interposer is bonded to a base circuit sheet, the interposer having a semiconductor chip mounted on a sheet-like chip holding member and having an interposer-side terminal as a connection terminal extending from the semiconductor chip, the base circuit sheet formed from a sheet-like base member and provided with a base-side terminal on a surface thereof, the method comprising:
a base circuit forming step of forming the base-side terminal in a continuous base member that is the base member in continuous sheet form;
an arranging/bonding step of arranging the interposer on a surface of the continuous base member on which the base-side terminal is formed, with the interposer-side terminal and the base-side terminal facing each other, and bonding the interposer; and
a separating step of cutting out the electronic component from the continuous base member to which the interposer is bonded,
in which, for the common continuous base member, each of the steps is repeated in parallel while the continuous base material is being advanced.

In the electronic component manufacturing method of the above-described first invention, each of the steps is repeated in parallel on the common continuous base member. Furthermore, in this electronic component manufacturing method, each of the steps is performed while the continuous base member is advanced without stopping the continuous base member.

According to the electronic component manufacturing method of the above-described first invention, each of the steps can be continuously performed on the continuous base member and it is possible to fabricate the electronic component with very high production efficiency.
Particularly, in the electronic component manufacturing method of the above-described first invention, the continuous base member is used, and the base-side terminal is formed and the interposer is bonded on a surface of the continuous base member. For this reason, it is easy to maintain the forming accuracy of the base-side terminal and the bonding accuracy of the interposer.

As described above, according to the electronic component manufacturing method of the above-described first invention, it is possible to fabricate the electronic component that has high product accuracy and is excellent in quality.

The second invention provides an electronic component manufacturing apparatus for fabricating an electronic component in which an interposer is bonded to a base circuit sheet, the interposer having a semiconductor chip mounted on a sheet-like chip holding member and having an interposer-side terminal as a connection terminal extending from the semiconductor chip, the base circuit sheet formed from a sheet-like base member and provided with a base-side terminal on a surface thereof, the electronic component manufacturing apparatus comprising:
a converter unit having a first anvil roller configured to rotate while holding, on a substantially cylindrical peripheral surface, the base member in continuous sheet form, or continuous base member, having the base-side terminal continuously provided on the surface thereof and to advance the continuous base member, and an end-effector able to hold and revolve the interposer along a substantially circumscribed circle with the peripheral surface of the first anvil roller, arranging the interposer one after another on the surface of the continuous base member so that the base-side terminal of the continuous base member and the interposer-side terminal face each other;
a press unit having a second anvil roller able to rotate while holding, on a substantially cylindrical peripheral surface, the continuous base member having the interposer arranged thereon and to advance the continuous base member, and a bonding head able to face a peripheral surface of the second anvil roller with a prescribed gap and to press and bond the interposer, which has been fed under pressure into the prescribed gap, on the continuous base member; and
a cutting unit that can cut out the electronic component from the continuous base member by a combination of a third anvil roller configured to rotate while holding the continuous base member having the interposer bonded thereon on a substantially cylindrical peripheral surface and can advance the continuous base member, and a die cut roller that circumscribes the third anvil roller via the continuous base member and is provided, on a peripheral surface thereof, with a cutting edge.

The electronic component manufacturing apparatus of the above-described second invention has the converter unit for arranging the interposer on the surface of the continuous base member, and the press unit for pressing and bonding the interposer arranged on the continuous base member, and the cutting unit for cutting out the electronic component as a final product, from the continuous base member to which the interposers have been continuously bonded.

The converter unit, the press unit and the cutting unit are all units that handle the continuous base member. For this reason, the electronic component manufacturing apparatus can perform its work continuously and with high production efficiency by arranging each of the units in tandem.

As described above, according to the electronic component manufacturing apparatus of the above-described second invention, by increasing the production efficiency, it is possible to fabricate the electronic component with excellent cost competitiveness, and to reduce the manufacturing cost thereof.

### Brief Description of the Drawings

Figure 1 is a block diagram that shows the general construction of an apparatus for manufacturing electronic components in Embodiment 1;
Figure 2 is a perspective view that shows an RF-ID medium, which is an electronic component, in Embodiment 1;
Figure 3 is a block diagram that shows the construction of a converter unit in Embodiment 1;
Figure 4 is a perspective view that shows a continuous base member in Embodiment 1;
Figure 5 is a front view that shows an end unit constituting a converter unit in Embodiment 1;
Figure 6 is a sectional view that shows the sectional construction of an end unit in Embodiment 1 (a sectional view taken in the direction of the arrows B-B in Figure 5);
Figure 7 is a perspective view that shows the construction of an end unit in Embodiment 1;
Figure 8A is a sectional view that shows the sectional construction of an end-effector constituting an end unit in Embodiment 1;
Figure 8B is a sectional view that shows the sectional construction of an end-effector constituting an end unit in Embodiment 1;
Figure 8C is a sectional view that shows the sectional construction of an end-effector constituting an end unit in Embodiment 1;
Figure 9 is an explanatory diagram to explain an end-effectors revolving along the same circumference in Embodiment 1;
Figure 10 is an explanatory diagram to explain how a press unit works a continuous base member in Embodiment 1;
Figure 11 is a side view that shows a press unit in Embodiment 1;
Figure 12 is a sectional view that shows the sectional construction of a press unit in Embodiment 1 (a sectional view taken in the direction of the arrows C-C in Figure 11);
Figure 13 is a front view that shows a cutting unit in Embodiment 1;
Figure 14 is a block diagram that shows the construction of an interposer cutting unit in Embodiment 1;
Figure 15 is a graph to explain the revolving movement of all end-effectors in Embodiment 1;
Figure 16 is a graph to explain the revolving movement of a specific end-effector in Embodiment 1;
Figure 17 is a sectional view that shows the sectional construction of a continuous base member on which interposers are arranged in Embodiment 1 (a sectional view taken in the direction of the arrows A-A in Figure 4);
Figure 18 is an explanatory view that shows how a press unit works in Embodiment 1;
Figure 19 is a sectional view that shows the sectional construction of a continuous base member worked by a press unit in Embodiment 1;
Figure 20 is a sectional view that shows the sectional construction of a continuous base member worked by a press unit in Embodiment 1 (a sectional view taken in the direction of the arrows D-D in Figure 19);
Figure 21 is a sectional view that shows other protrusions in Embodiment 1; and
Figure 22 is a diagram that shows the construction of a laminating unit, in particular, of an apparatus for manufacturing electronic components in Embodiment 2.

### Description of Symbols

- 1: Electronic component manufacturing apparatus
- 21: Interposer cutting-out unit
- 22: Pattern printing unit
- 3: Converter unit
- 35: First anvil roller
- 4: Press unit
- 41: Second anvil roller
- 5: RF-ID medium (electronic component)
- 50: Interposer
- 51: IC chip (semiconductor chip)
- 53: Chip holding member
- 530: Continuous-chip holding member
- 60: Base circuit sheet
- 61: Base member
- 610: Continuous base member
- 7: Cutting unit
- 71: Third anvil roller
- 8: Laminating unit

### Best Mode for Carrying Out the Invention

In the above-described first and second inventions, the chip holding member and the base member can be formed from materials, such as synthetic resins, for example, a PET film, PPS resins, PLA resins and general-purpose engineering plastics, paper, nonwoven fabrics, metal materials, for example, aluminum foil and copper foil, and glass. Incidentally, the material for the chip holding member and the material for the base member may be a combination of the same material or may be a combination of different materials.

It is preferred that in the arranging/bonding step, by use of a converter unit having a first anvil roller configured to rotate while holding the continuous base member on a substantially cylindrical peripheral surface and to advance the continuous base member, and an end-effector configured to hold and revolve the interposer along a substantially circumscribed circle with the peripheral surface of the first anvil roller,
the interposer is arranged on the surface of the continuous base member while the end-effector is being operated so that the relative speed of the interposer becomes substantially zero with respect to the base-side terminal of the continuous base member held by the first anvil roller in a rotating condition.

In this case, it is possible to arrange the interposer continuously and at a high speed without stopping the advancing operation of the continuous base member in the converter unit. In the converter unit, the relative speed with respect to the continuous base member is made substantially zero in arranging the interposer. For this reason, it is possible to fabricate the electronic component excellent in quality by suppressing the occurrence of initial troubles. Also, if the above-described relative speed is made substantially zero, the quality of the electronic component can be increased by improving the arrangement accuracy of the interposer.

It is preferred that the arranging/bonding step uses a press unit having a second anvil roller configured to rotate while holding the continuous base member on a substantially cylindrical peripheral surface, and a bonding head configured to face a peripheral surface of the second anvil roller with a prescribed gap and to press and bond the interposer on the continuous base member, and
in response to the second anvil roller being rotated, the interposer arranged on the continuous base member, along with the continuous base member, is fed under pressure into the prescribed gap and the interposer is bonded under pressure to the continuous base member.

In this case, it is possible to press and bond the interposer one after another by continuously feeding the interposer under pressure toward the prescribed gap without stopping the advancing operation of the continuous base member in the press unit. Thus, the production efficiency of the electronic components can be increased. For this reason, it is possible to further improve the cost competitiveness of this electronic component in the market by reducing the manufacturing cost of the electronic component.

It is preferred that the continuous base member is formed from a plastic material, and the second anvil roller is provided, on the peripheral surface thereof, with a convexity-formed portion including protrusions that protrude so as to face part of the base-side terminal, and
in the arranging/bonding step, with an insulating adhesive having electrical insulating properties disposed at least between the base-side terminal and the interposer-side terminal, the continuous base member and the interposer is fed into the prescribed gap and the part of the base-side terminal is caused to protrude and deformed by the protrusion, whereby the part of the base-side terminal is caused to abut against the interposer-side terminal.

In this case, part of the base-side terminal on the base-side terminal can be caused to protrude and deformed by the protrusion provided on the second anvil roller. And the insulating adhesive is caused to flow out positively from between this protruding deformed part and the interposer-side terminal, whereby it is possible to cause the interposer-side terminal and the base-side terminal to directly abut against each other. This enables electrical connection between the base-side terminal and the interposer-side terminal to be realized with high certainty.

On the other hand, the insulating adhesive remains as it is in the gap between the non-protruding portion of the base-side terminal and the interposer-side terminal. For this reason, the adhesive bonding force of this remaining insulating adhesive enables physical connection, i.e., adhesive bonding between the interposer-side terminal and the base-side terminal to be realized with high certainty.

Incidentally, it is possible to use hot melts, epoxy-resin adhesive, acrylic adhesives, elastic adhesives and the like as the insulating adhesive. Furthermore, it is preferred that a thermoplastic adhesive be used as the insulating adhesive and that a heater be incorporated in at least either the second anvil roller or the bonding head. In this case, it is possible to increase the flowability of the thermoplastic insulating adhesive by heating the thermoplastic insulating adhesive. This enables electrical connection between the base-side terminal and the interposer-side terminal to be realized with high certainty by causing the insulating adhesive to flow out with high certainty from the portion where the interposer-side terminal and the base-side terminal directly abut each other.

Furthermore, by heating using the heater the location where the protruding deformed part and the interposer-side terminal are in contact with each other, the two can be pressure bonded under heat (thermocompression bonding). By performing pressure-bonding under heat, it is possible to improve the bonding condition in the location where the interposer-side terminal and the base-side terminal directly abut each other. In this case, the electrical connection between the interposer-side terminal and the base-side terminal can be made more certain and the good connecting condition can be maintained in a highly reliable condition for a long period of use.

It is preferred that the semiconductor chip is an IC chip for RF-ID media and that the base circuit sheet is provided with an antenna pattern to be electrically connected to the IC chip.
"RF-ID" is an abbreviation of Radio-Frequency Identification. Excellent products having high reliability can be manufactured with very good efficiency when RF-ID media are fabricated by using the electronic component manufacturing method of the above-described first invention. Because in particular RF-ID media require cost reductions, the advantage of the electronic component manufacturing method of the above-described first invention is particularly beneficial for the media in that the interposer bonding device provides improved production efficiency. Incidentally, according to this electronic component manufacturing method, it is possible to fabricate not only RF-ID media for noncontact ID, but also RF-ID media for contact ID.

In the above-described second invention, it is preferred that the converter unit is configured to arrange the interposer on the surface of the continuous base member while the end-effector is being operated so that the relative speed of the interposer becomes substantially zero with respect to the base-side terminal of the continuous base member held by the first anvil roller in a rotating condition.

In this case, it is possible to arrange the interposer continuously and at a high speed without stopping the advancing operation of the continuous base member in the converter unit. In the converter unit, the relative speed with respect to the continuous base member is made substantially zero in arranging the interposer. For this reason, there is no fear that excessive stress might act on the interposer or the continuous base member in arranging the interposer in the continuous base member. Therefore, it is possible to fabricate the electronic component excellent in quality by suppressing the occurrence of initial troubles in the electronic component. Also, if the above-described relative speed is made substantially zero, the quality of the electronic component can be increased by improving the arrangement accuracy of the interposer.

It is preferred that the continuous base member is formed from a plastic resin material and that the second anvil roller is provided, on the peripheral surface thereof, with a convexity-formed portion including protrusions that protrude toward part of a rear surface region of the base-side terminal provided in the continuous base member.
In this case, part of the base-side terminal is caused to protrude and deformed by the protrusion provided in the second anvil roller. And this protruding deformed part and the interposer-side terminal can be caused to abut against each other with high certainty. This enables electrical connection between the base-side terminal and the interposer-side terminal to be realized with high reliability.

It is preferred that the apparatus configured to bond the interposer to the continuous base member with an adhesive disposed at least in the gap between the interposer-side terminal and the base-side terminal within the gap formed by the interposer and the continuous base member by facing each other, and that the adhesive is an insulating adhesive having electrical insulating properties.

In this case, it is possible to dramatically suppress the occurrence of troubles, such as an electrical short circuit, compared to a case where the interposer and the continuous base member are bonded together by use of an electrically conductive adhesive, for example. On the other hand, it is possible to cause part of the base-side terminal to protrude and be deformed by the protrusion. At this time, the insulating adhesive is caused to flow out positively from between this protruding deformed part and the interposer-side terminal, whereby it is possible to cause the base-side terminal and the interposer-side terminal to directly abut each other. This enables electrical connection between the base-side terminal and the interposer-side terminal to be realized with high certainty. On the other hand, the insulating adhesive remains as it is in the gap between the non-protruding portion of the base-side terminal and the interposer-side terminal. For this reason, the adhesive bonding force of this remaining insulating adhesive enables physical connection, i.e., adhesive bonding between the interposer-side terminal and the base-side terminal to be realized with high certainty.

It is preferred that the press unit configured to apply ultrasonic vibrations to a location where the interposer and the continuous base member abut each other.
In this case, by applying ultrasonic vibrations to a location where the interposer-side terminal and the base-side terminal are in direct contact with each other, it is possible to cause the interposer-side terminal and the base-side terminal to be fusion bonded. And by this ultrasonic wave bonding, it is possible to further improve the reliability of electrical connection between the interposer-side terminal and the base-side terminal and hence it is possible to further increase the durability of the bond.

It is preferred that the second anvil roller has the convexity-formed portion provided in an extending manner along the whole circumference of the peripheral surface thereof.
In this case, it is possible to perform the bonding of the interposer in any circumferential position on the peripheral surface of the second anvil roller. Because of this, it is possible to arbitrarily set the arrangement pitch of the interposer in the continuous base member and it is possible to perform the bonding of the interposer with high versatility.

It is preferred that the interposer has a pair of the interposer-side terminals arranged opposite to each other, with the semiconductor chip interposed therebetween, and
the second anvil roller has two convexity-formed portions spaced along a rotating axis thereof and the second anvil roller is configured to hold the continuous base member with each of the convexity-formed portions facing different base-side terminals.
In this case, it is possible to avoid the possibility that the convexity-formed portion applies an excessive load on the semiconductor chip. Because of this, it is possible to fabricate the electronic component having stable quality by suppressing the occurrence of initial troubles in the semiconductor chip.

It is preferred that the apparatus is provided with an interposer cutting-out unit configured to cuts out the interposer from a continuous-chip holding member one by one, which is the chip holding member in continuous sheet form on which the semiconductor chip is mounted, and that the converter unit configured to receive the interposer from the interposer cutting-out unit.
In this case, it is possible to fabricate the electronic component with better efficiency by using each of the interposers cut out by use of the interposer cutting unit.

It is preferred that the semiconductor chip is an IC chip for RF-ID media and that the base circuit sheet is provided with an antenna pattern to be electrically connected to the IC chip.
In this case, it is possible to fabricate the RF-ID media of low cost with high production efficiency by using the electronic component manufacturing apparatus.

### Embodiments

### (Embodiment 1)

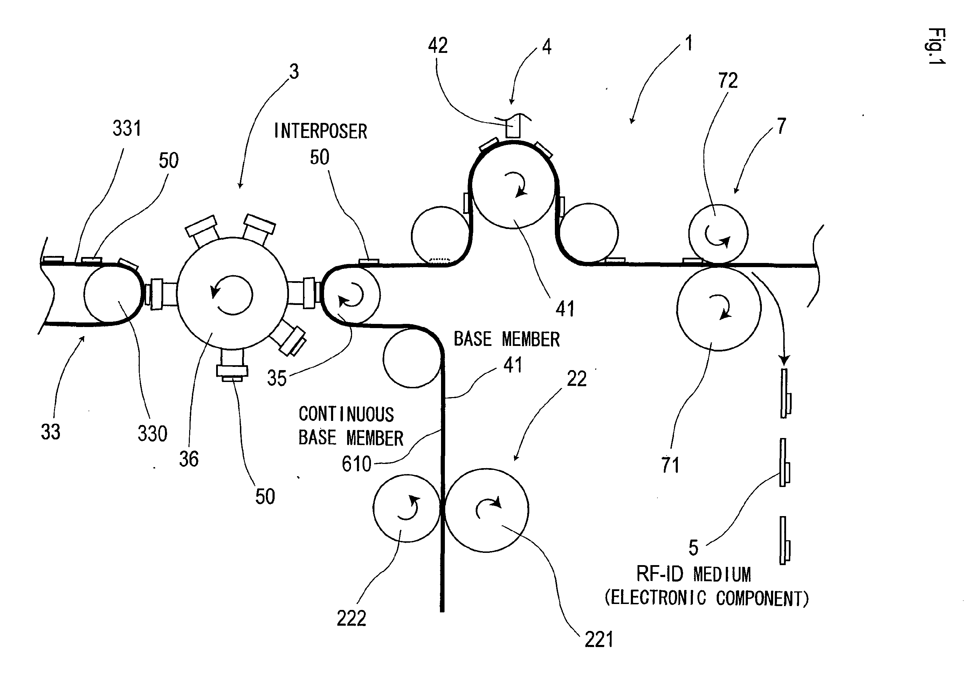

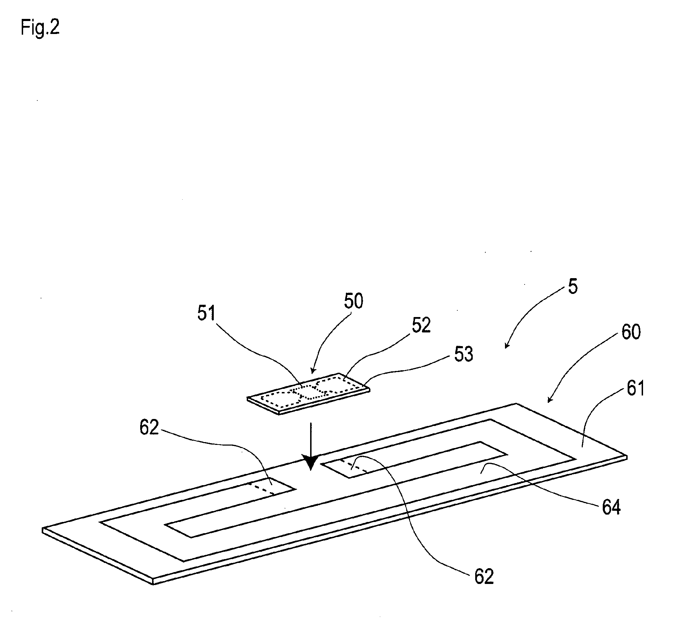

This embodiment relates to a method for fabricating an electronic component 5 including an interposer 50 in sheet piece form on which a semiconductor chip 51 is mounted. This embodiment will be described with reference to Figures 1 to 21.
As shown in Figures 1 and 2, the electronic component manufacturing method of this embodiment relates to an electronic component 5 in which an interposer 50, in which a semiconductor chip 51 is mounted on a sheet-like chip holding member 53 and which has an interposer-side terminal 52, which is a connection terminal provided in an extending manner from the semiconductor chip 51, is bonded to a base circuit sheet 60 that is formed from a sheet-like base member 61 and is provided, on a surface thereof, with a base-side terminal 62.

As shown in Figures 1 and 2, this electronic component manufacturing method includes a base circuit forming step of forming the base-side terminal 62 in a continuous base member 610 that is the base member 61 in continuous sheet form, an arranging/bonding step of arranging the interposer 50 on a surface of the continuous base member 610 on which the base-side terminal 62 is formed, with the interposer-side terminal 52 and the base-side terminal 62 caused to face each other, and bonding the interposer 50, and a separating step of cutting out the electronic component 5 from the continuous base member 610 to which the interposer 50 is bonded.
Particularly, in this electronic component manufacturing method, for the common continuous base member 610, each of the steps is repeated in parallel while the continuous base material 610 is being advanced.
This method will be described in detail below.

First, a description will be given of the electronic component 5 fabricated in this embodiment As shown in Figure 2, this electronic component 5 is an RF-ID (Radio-Frequency Identification) medium for noncontact ID (hereinafter written as an RF-ID medium 5, as required). This RF-ID media 5 is obtained by laminating the interposer 50 on which an IC chip (hereinafter written as an IC chip 51, as required) for RF-ID as the semiconductor chip 51 is mounted and the base circuit sheet 60 provided with an antenna pattern 64 including the base-side terminal 62 and bonding the two together.

As shown in Figure 2, the interposer 50 is such that the IC chip 51 is mounted on a surface of the chip holding member 53 in the form of a 200 µm thick sheet formed from PSF. On the surface of this chip holding member 53, there are provided an electrically conductive pad (not shown) that is to be electrically connected to an electrode pad (not shown) of the IC chip 51 and the interposer-side terminal 52 that is provided in an extending manner from this electrically conductive pad. Incidentally, in this embodiment, the electrically conductive pad and the interposer-side terminal 52 were formed from an electrically conductive ink.

Incidentally, as the material for the chip holding member 53, PC, coated paper and the like can be adopted in addition to the PSF of this embodiment. In order to protect the electrical connections between the electrically conductive pad and the electrode pad, it is also advisable to use an underfill material, a potting material and the like. As the method for forming the interposer-side terminal 52 and the like, it is also good to adopt methods, such as copper etching, dispensing, metal foil sticking, metal direct vapor deposition, transfer of a vapor deposited metal film and formation of an electrically conductive polymer layer in place of the method of printing an electrically conductive ink in this embodiment.

As shown in Figure 2, the base circuit sheet 60 is such that the antenna pattern 64 formed from an electrically conductive ink is provided on a surface of the 100 µm thick thermoplastic base member 61 formed from PET. This antenna pattern 64 has a substantially annular shape that is discontinuous in one place. In the antenna pattern 64, at both ends that form this one place are provided base-side terminals 62 to electrically connect to the interposer-side terminal 52.

Incidentally, as in the interposer-side terminal 52 formed in the chip holding member 53, it is also possible to adopt an antenna pattern 64 formed by methods, such as copper etching foil, dispensing, metal foil sticking, metal direct vapor deposition, transfer of a vapor deposited metal film and formation of an electrically conductive polymer layer in place of an antenna pattern 64 formed from an electrically conductive ink. As the material for the base member 61, PET-G, PC, PP, nylon, paper and the like can be used in addition to the PET of this embodiment. Furthermore, as the ink material for the electrically conductive ink, it is possible to use silver, graphite, silver chloride, copper, nickel and the like.

Next, a description will be given of the electronic component manufacturing apparatus 1 for fabricating the RF-ID medium 5.
As shown in Figure 1, this electronic component manufacturing apparatus 1 has a converter unit 3 for arranging the interposer 50 one after another on the continuous base member 610, a press unit 4 for pressing the interposer 50 toward the continuous base member 610, thereby to bond the interposer, and a cutting unit 7 for cutting out the RF-ID medium 5 from the continuous base member 610 to which the interposer 50 is bonded.

As shown in Figures 1, 3 and 4, the converter unit 3 has a first anvil roller 35 configured to rotate while holding, on a substantially cylindrical peripheral surface, the base member 61 in continuous sheet form, or the continuous base member 610, having the base-side terminal 62 continuously provided on the surface thereof and to advance the continuous base member 610, and end-effectors 371 to 376 configured to hold and revolve the interposer 50 along a substantially circumscribed circle with the peripheral surface of the first anvil roller 35. This converter unit 3 arranges the interposer 50 one by one on the surface of the continuous base member 610 so that each of the base-side terminals 62 of the continuous base member 610 and the interposer-side terminal 52 face each other.

As shown in Figures 1, 10 and 11, the press unit 4 has a second anvil roller 41 configured to rotate while holding, on a substantially cylindrical peripheral surface, the continuous base member 610 having the interposer 50 arranged thereon and to advance the continuous base member 610, and a bonding head 42 configured to face a peripheral surface of the second anvil roller 41 with a prescribed gap G. This press unit 4 bonds the interposer 50, which has been fed under pressure into this prescribed gap G, to the continuous base member 610 under pressure.

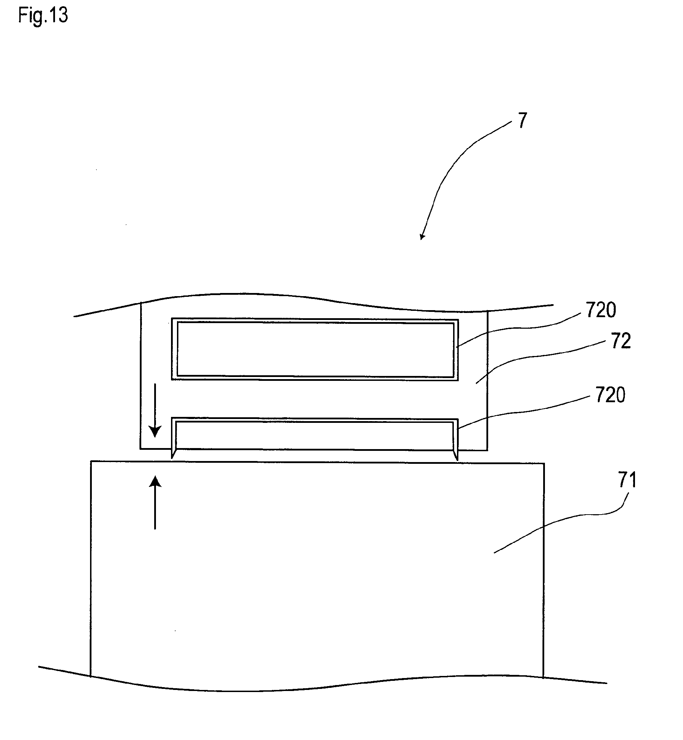

As shown in Figures 1 and 13, the cutting unit 7 cuts out the RF-ID medium 5 from the continuous base member 610 by a combination of a third anvil roller 71 configured to rotate while holding, on a substantially cylindrical peripheral surface, the continuous base member 610 having the interposer bonded thereto and to advance the continuous base member 610, and a die cut roller 72 that circumscribes the third anvil roller 71 via continuous base member 610 and is provided, on a peripheral surface thereof, with a cutting edge 720.
A detailed description will be given below of the construction of the electronic component manufacturing apparatus 1 of this embodiment, including each of the units.

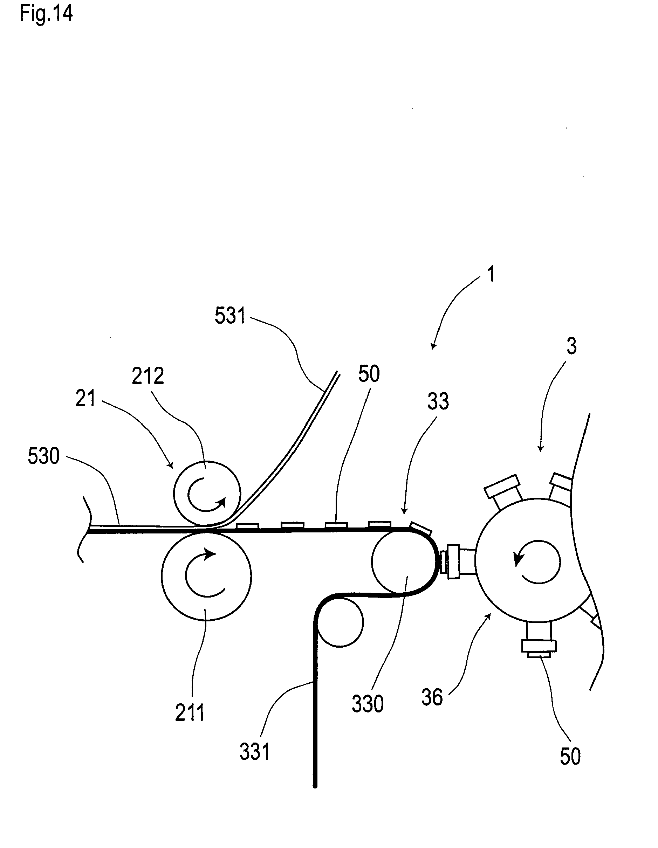

The electronic component manufacturing apparatus 1 of this embodiment is provided with an interposer cutting-out unit 21 shown in Figure 14 and a pattern printing unit 22 shown in Figure 1 in addition to each of the units. The interposer cutting-out unit 21 cuts out an interposer 50 in individual-piece form from a continuous-chip holding member 530, which is the chip holding member 53 in continuous sheet form on which the IC chip 51 (see Figure 2) is continuously mounted. And the pattern printing unit 22 forms the antenna pattern 64 at substantially constant intervals on the surface of the continuous base member 610.

First, a description will be given of the interposer cutting-out unit 21. The interposer cutting-out unit 21 has a rotating roller 211 that holds and advances a continuous-chip holding member 530, and a die cut roller 212 that circumscribes the rotating roller 211 via the continuous-chip holding member 530. This die cut roller 212 has, on a peripheral surface thereof, a cutting edge (not shown) having the shape of a substantially rectangular annulus for punching the interposer 50 from the continuous-chip holding member 530. And the interposer cutting-out unit 21 of this embodiment cuts out the interposer 50 one by one from the continuous-chip holding member 530, which has been introduced to between the peripheral surface of the rotating roller 211 and the die cut roller 212. Also, this interposer cutting-out unit 21 discharges a scrap sheet 531 after the punching of the interposer 50.

Next, the pattern printing unit 22 will be described. This pattern printing unit 22 has a rotating roller 221 that holds and advances the continuous base member 610, and a stamp roller 222 configured to rotate while circumscribing the rotating roller 221 via the continuous base member 610. The stamp roller 222 has a stamp pattern corresponding to the antenna pattern 64, which is formed on the periphery thereof, and prints the antenna pattern 64 one by one on the surface of the continuous base member 610 while rotating. Incidentally, the electronic component manufacturing apparatus 1 of this embodiment is provided with an adhesive application unit (not shown), which is a roll type printing machine and constructed substantially in the same manner as the pattern printing unit 22 described above. In this embodiment, this adhesive application unit is disposed in series between the pattern printing unit 22 and the converter unit 3.

Next, the converter unit 3 will be described in detail. As shown in Figures 1, 3 and 4, the converter unit 3 of this embodiment is configured to be supplied with the continuous base member 610 having the antenna pattern 64 continuously provided to the surface of the continuous sheet fabricated from resin. This converter unit 3 arranges the interposer 50 one by one on the surface of this continuous base member 610. This converter unit 3 arranges the interposer 50 on the surface of the continuous base member 610, with the pair of interposer-side terminals 52 of the interposer 50 facing the pair of base-side terminals 62 of each of the antenna patterns 64 (see Figure 2).

As shown in Figures 1, 3 and 4, the converter unit 3 is provided with a first conveying device 33 configured to hold and convey the interposer 50 received from the interposer cutting-out unit 21 (see Figure 14), the first anvil roller 35 configured to hold and advance the continuous base member 610, and an end unit 36 that receives the interposer 50 from the first conveying device 33 and arranges the interposer 50 on the surface of the continuous base member 610 held by the first anvil roller 35.

As shown in Figures 1, 3 and 14, the first conveying device 33 holds the interposer 50 in individual-piece form on the surface of a conveyor belt 331 held by a substantially cylindrical rotating roller 330. This first conveying device 33 receives the interposer 50 from the interposer cutting-out unit 2 and then delivers the received interposer 50 to the end unit 36. Incidentally, the first conveying device 33 sucks the interposer 50 by bringing a hole opened on the surface of the conveyor belt 331 under negative pressure and delivers the interposer 50 to the end unit 36 by canceling the suction or bringing the hole under positive pressure.

As shown in Figures 1, 3 and 4, the first anvil roller 35 rotates at a substantially constant rotation speed and advances the continuous base member 610 in which the antenna pattern 64 is continuously provided. Incidentally, in this embodiment, the first conveying device 33 and the first anvil roller 35 are each controlled so as to operate at a substantially constant speed by a driving source and a drive control system, which are not shown.

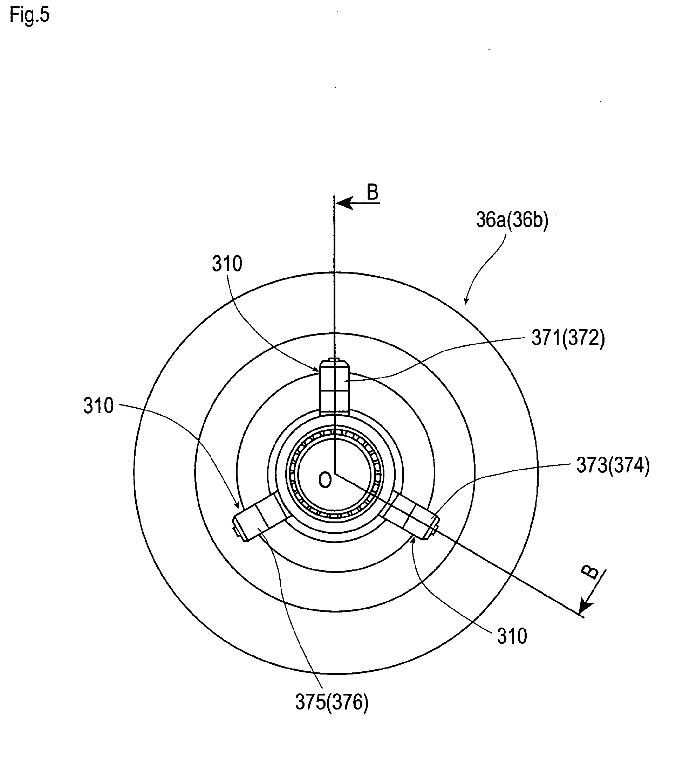

The end unit 36 is formed by combining two end units 36a, 36b of the same specification. And as shown in Figures 5 to 7, each of the end units 36a (36b) is formed by combining three coaxial rotors 310. The construction of the end unit 36a (36b) is such that each of the coaxial rotors 310 mutually supports other coaxial rotors 310. Concretely, the inner ring of one of the bearings adjacent axially to each other and the outer ring of the other bearing is integrally connected via a connecting member. And in the combinations of the inner ring and outer ring connected via connecting members 391, 393, 395, end-effectors 371, 373, 375 are integrally fixed to the inner circumferential side of the inner ring, and driving wheels 392, 394, 396 are fixed to the outer ring by being externally fitted thereto.

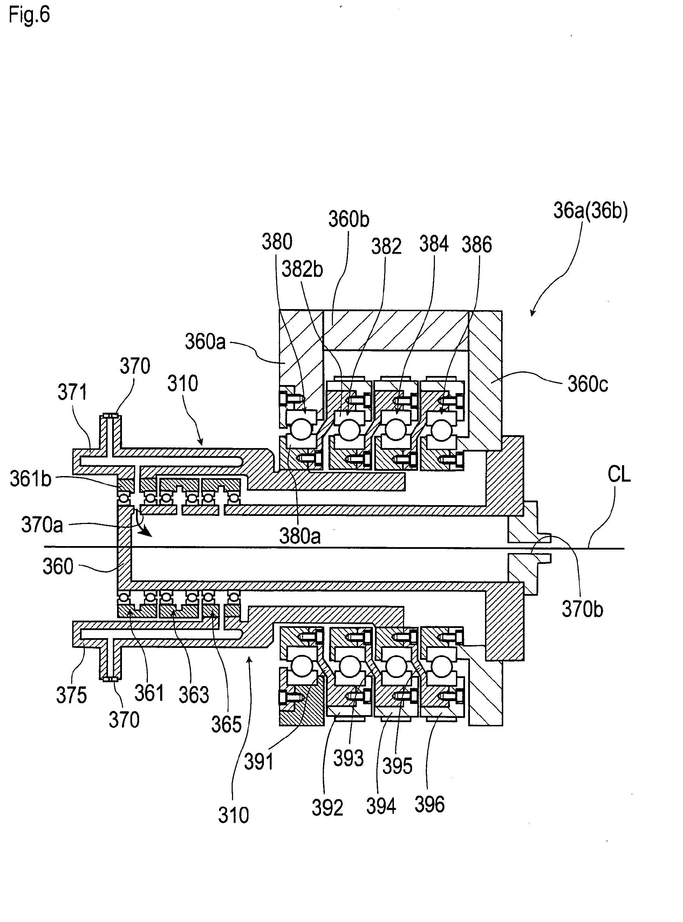

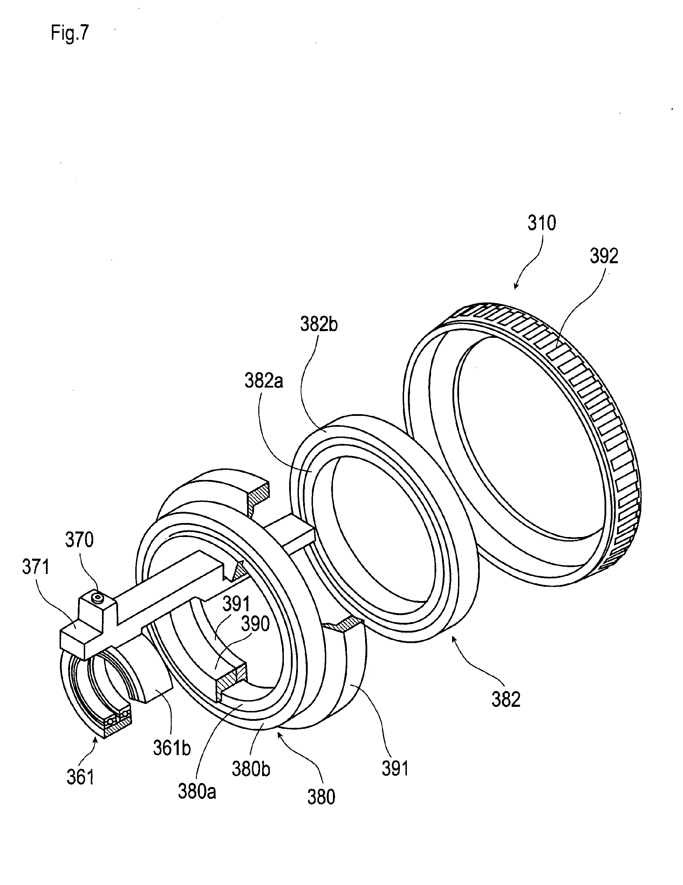

As shown in Figures 6 and 7, the end unit 36a (36b) has structural members 360a, 360b, 360c and four bearings 380, 382, 384, 386 that are supported by these structural members 360a, 360b, 360c and coaxially arranged. And on the inner circumferential side of each of the bearings 380, 382, 384, 386, there is disposed a hollow shaft 360, which is a structural member disposed so as to protrude toward a leading end portion of the end-effectors 371, 373, 375 (372, 374, 376). And on the peripheral side of the protrusion in this hollow shaft 360, there are disposed bearings 361, 363, 365 for supporting the revolving movement of the end-effectors 371, 373, 375 (372, 374, 376) so as to correspond to each end-effector.

As shown in Figures 6 to 8C, each of the end-effectors 371, 373, 375 (372, 374, 376) is a bar-like member that is arranged substantially parallel to the central axis CL and eccentrically, and this member is rotatably supported so as to be able to revolve around the central axis CL. Each of the end-effectors 371, 373, 375 (372, 374, 376) is provided, at the leading end portion thereof, with a holding surface 370s for sucking and holding the interposer 50 (see Figure 1). This holding surface 370s is provided with a hole for air pressure control and holds the interposer 50 by sucking interposer 50 under negative pressure. On the other hand, in delivering the interposer 50 to the continuous base member 610 held by the first anvil roller 35, the holding surface 370s releases the interposer 50 by bringing the hole under atmospheric pressure or positive pressure.

As shown in Figures 6 to 8C, each of the coaxial rotors 310 is provided with one end-effector. For example, an end-effector 371 is constructed in such a manner that the leading end side thereof (the holding surface 370s side) is fixed to the periphery of an outer ring 361b of the bearing 361 and the tail end side thereof is fixed to the inner circumference of an inner ring 380a of the bearing 380. The inner ring 380a of the baring 380 is integrally connected to an outer ring 382b of the axially adjacent bearing 382 via the connecting member 391. To the peripheral side of the outer ring 382b is fixed a driving wheel 392 via part of the connecting member 391. On the peripheral surface of the driving wheel 392, there is provided, for example, a transmission meshing groove (a precision gear or the like) for the rotational driving by a timing belt.

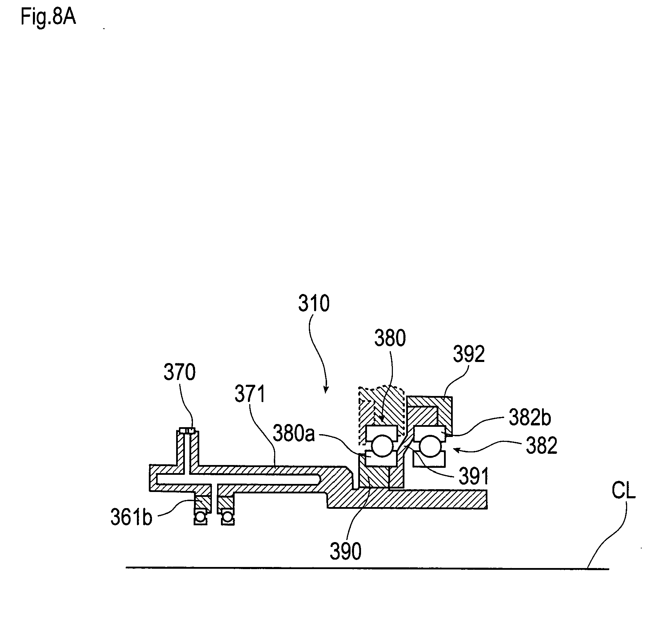

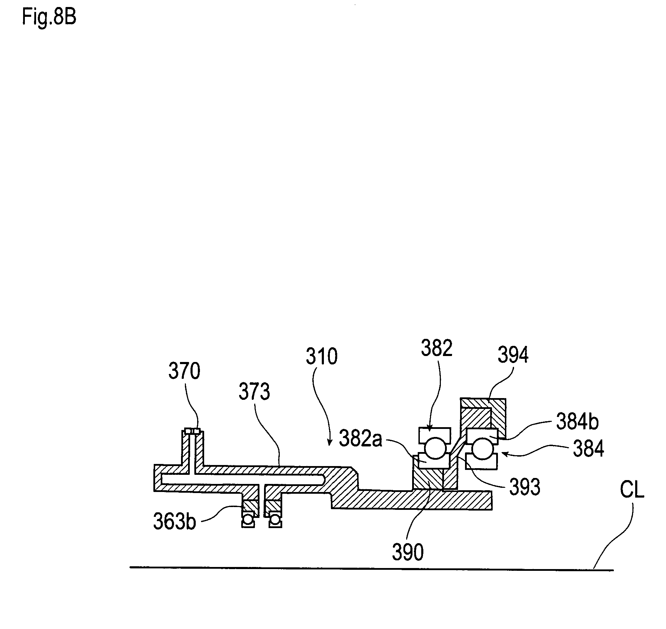

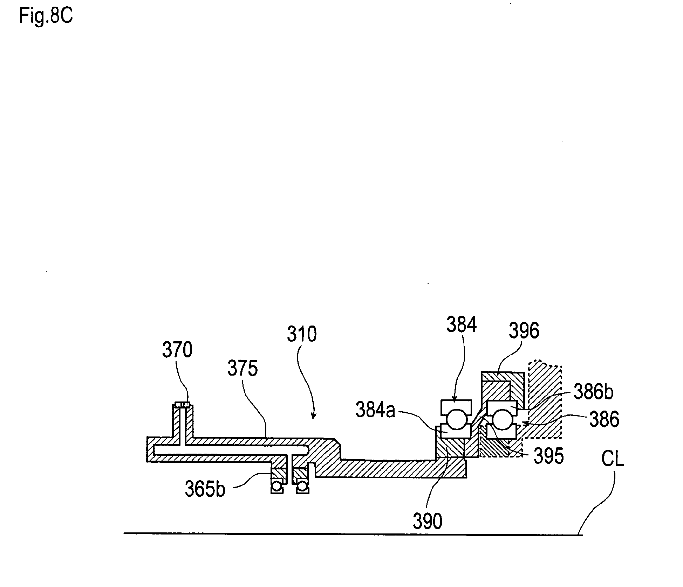

As shown in Figures 8A, 8B and 8C, in the end unit 36a (36b) of this embodiment, a rotational driving force is supplied to the three driving wheels 392, 394, 396 in three directions at circumferential equal intervals, with the central axis CL serving as the center. This cancels out the external pressure acting toward the axis center of the driving wheels 392, 394, 396 of each of the coaxial rotors 310. In the end unit 36a (36b), a general-purpose servo-controlled motor (an external motor) is connected to each of the driving wheels 392, 394, 396 independently of each other. This enables the revolving movement of each of the coaxial rotors 310 (the end-effectors 371, 373, 375 (372, 374, 376)) to be independently controlled.

As shown in Figures 6 to 8C, in the end unit 36a (36b) of this embodiment, an open space is provided on the periphery side of the driving wheels 392, 394, 396 because of the structure of the end unit 36a (36b). Therefore, various kinds of mechanism sections can be provided on the periphery side of the driving wheels 392, 394, 396. For example, it is also advisable to provide a direct driving mechanism capable of more accurate control in place of the above-described general-purpose servo-controlled motor.

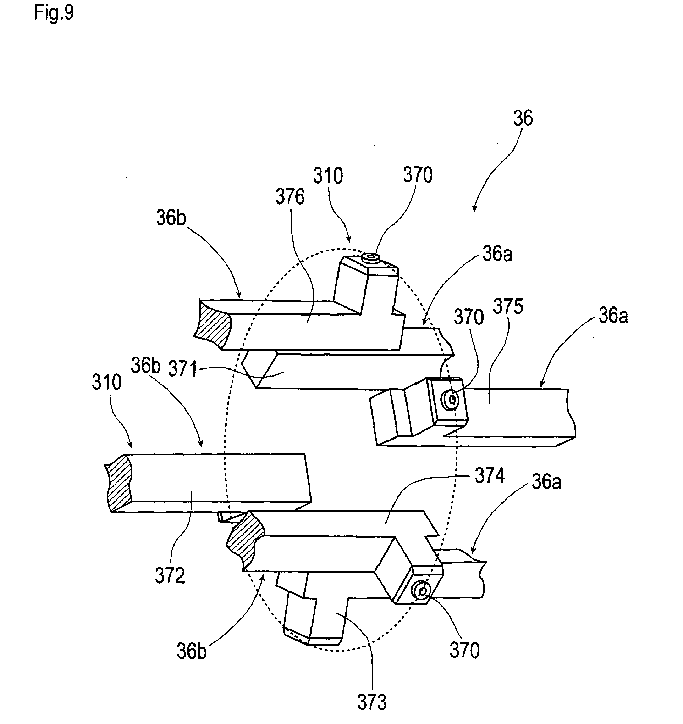

As shown in Figure 9, in the converter unit 3 of this embodiment, the two end units 36a, 36b are combined. One end unit 36a is provided with the end-effectors 371, 373, 375. The other end unit 36b is provided with the end-effectors 372, 374, 376. As shown in this figure, these two end units 36a, 36b are arranged opposite to each other so that all the end-effectors 371 to 376 revolve along the same circumference.

In the converter unit 3 constructed as described above, each of the end-effectors 371 to 376 around the same circumference is constructed so as to maintain its revolving order. And each of the end-effectors 371 to 376 synchronizes with the transfer operation of the first conveying device 33 and receives the interposer 50 from the first conveying device 33 when the relative speed is substantially zero. After that, each of the end-effectors 371 to 376 synchronizes with the rotation operation of the first anvil roller 35 and arranges the interposer 50 in the continuous base member 610 held by the first anvil roller 35 when the relative speed is substantially zero.

As shown in Figure 6, a through hole 370b is provided along the central axis CL at the end faces of the hollow shaft 360 of the end unit 36a (36b). A suction port of an unillustrated pump is connected to this through hole 370b. Therefore, the hollow part of the hollow shaft 360 is maintained at negative pressure by the action of the pump. A through hole 370a that pieces radially is provided in a peripheral wall surface of the hollow shaft 360. Furthermore, the bearings 361, 363, 365 are each provided with a hole that pierces radially and communicates with the hollow parts of the end-effectors 371, 373, 375 so as to communicate with the through hole 370a.

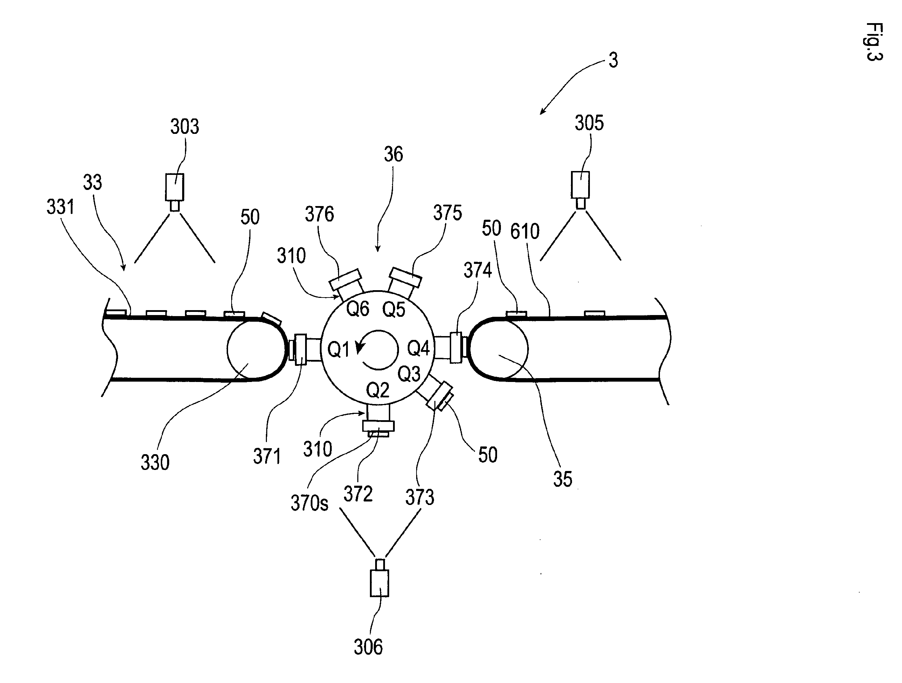

Particularly in this embodiment, as shown in Figures 3 and 6, the through hole 370a is provided in a prescribed circumferential position on the peripheral wall surface of the hollow shaft 360 so as to communicate with the end-effectors in the revolving section from the revolving position Q1 (strictly speaking, a position before Q1 so that the holding surface 370s sucks the interposer 50 in the rotational position Q1) to the rotational position Q4 (strictly speaking, a position before Q4 so that the holding surface 370s releases the interposer 50 in the revolving position Q3).

On the other hand, so that atmospheric pressure is introduced via the hole of the bearing 361 when the end-effector becomes located in the revolving position Q4, an atmospheric pressure introduction port (not shown) is provided in a prescribed circumferential position on the peripheral wall surface of the hollow shaft 360. Because of this, in the end unit 36a of this embodiment, the pressure of the hole of the holding surface 370s is appropriately controlled according to the rotation of the bearings 361, 363, 365 resulting from the revolution of each of the end-effectors 371, 373, 375.

As shown in Figure 3, the converter unit 3 of this embodiment has an imaging device (a measuring section) 303 for obtaining image data by photographing the conveying condition of the interposer 50 being conveyed by the first conveying device 33. In this embodiment, the image data is subjected to image processing and the conveying position and conveying speed of the interposer being conveyed are detected. And an unillustrated control device controls the revolving movement of each of the end-effectors 371 to 376 on the basis of the detected conveying position and conveying speed.

Furthermore, as shown in Figure 3, the converter unit 3 of this embodiment has an imaging device (a measuring section) 306 that photographs the condition of the interposer 50 held by the end-effectors 371 to 376 and an imaging device (a measuring section) 305 that photographs the continuous base member 610 held by the first anvil roller 35. On the basis of image data photographed by the imaging device 306, it is possible to detect abnormalities in the conveying intervals of the interposer 50, abnormalities in the posture thereof, the presence of foreign body and the like. Also, with the imaging device 305, it is possible to detect the conveying speed and conveying position of each of the antenna patterns 64 disposed on the surface of the continuous base member 610, antenna pattern abnormalities and the like. Incidentally it is also possible to use a lower-cost optical sensor in place of the imaging devices 303, 305, 306.

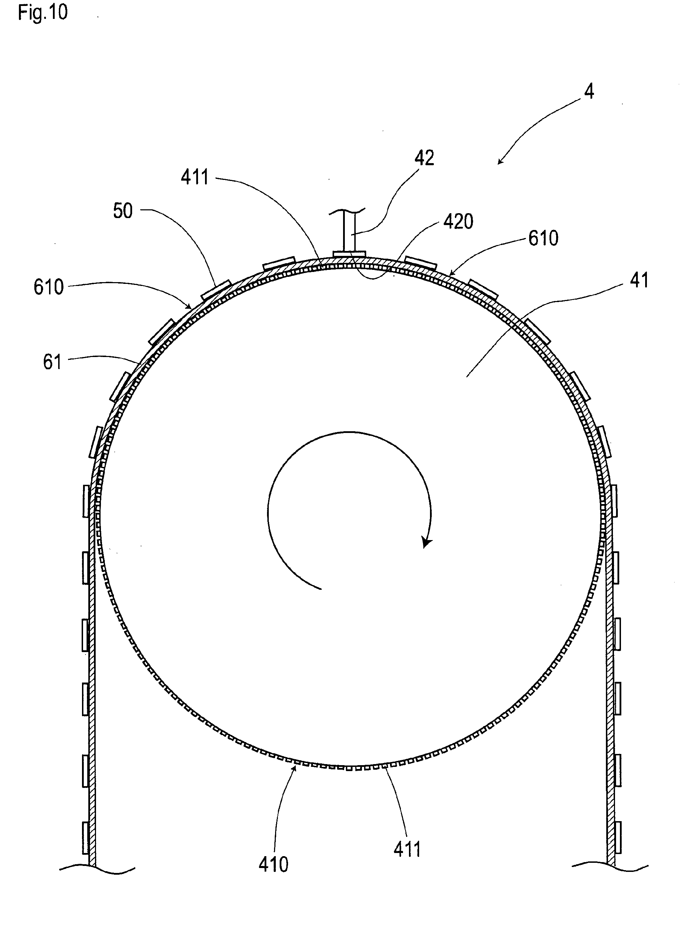

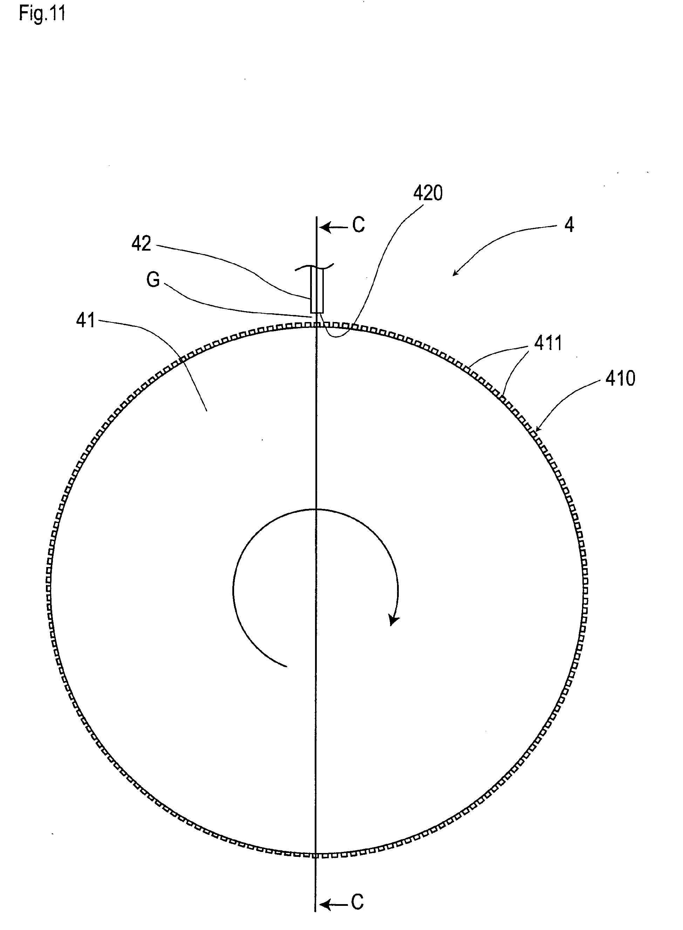

Next, the press unit 4 will be described. As shown in Figures 10 and 11, the press unit 4 of this embodiment is constituted by the second anvil roller 41 in the shape of a substantially cylindrical roller and the bonding head 42 having a pressing surface 420 that faces a peripheral surface of the second anvil roller 41 with a prescribed gap G.

As shown in Figures 1, 10 and 11, the second anvil roller 41 holds, on a substantially cylindrical external surface, the continuous base member 610 having the interposer 50 arranged thereon. The press unit 4 of this embodiment continuously performs the press and bonding of the interposer 50 with the continuous base member 610 having the interposer 50 arranged thereon.

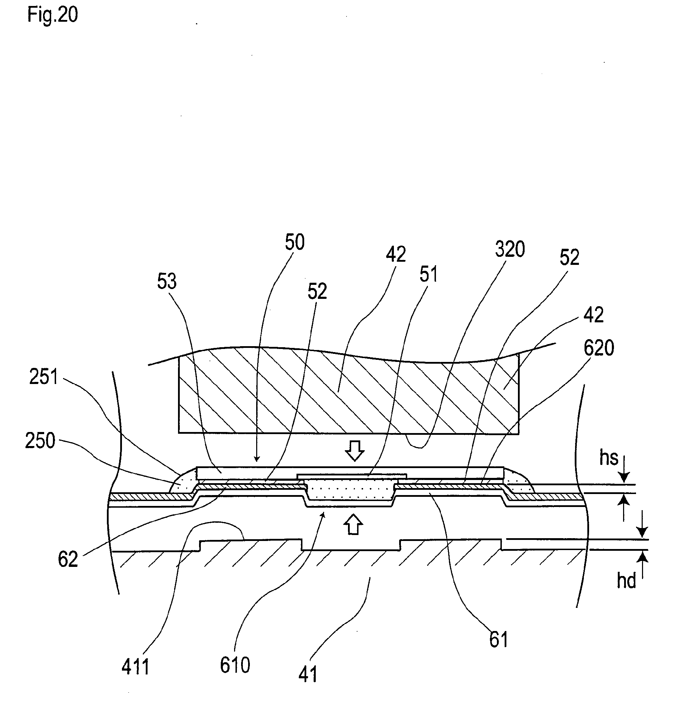

As shown in Figures 1, 10 to 12, the second anvil roller 41 holds the continuous base member 610 so that a pair of base-side terminals 62 is arranged along the direction of its axis center. On the peripheral surface of the second anvil roller 41, there are provided convexity-formed portions 410 in two rows corresponding to each of the base-side terminals 62. The convexity-formed portion 410 forms a substantially annular shape provided in an extending manner along the whole circumference of the second anvil roller 41. The convexity-formed portion 410 is provided so as to face each of the base-side terminals 62 of the continuous base member 610 (see Figure 20).

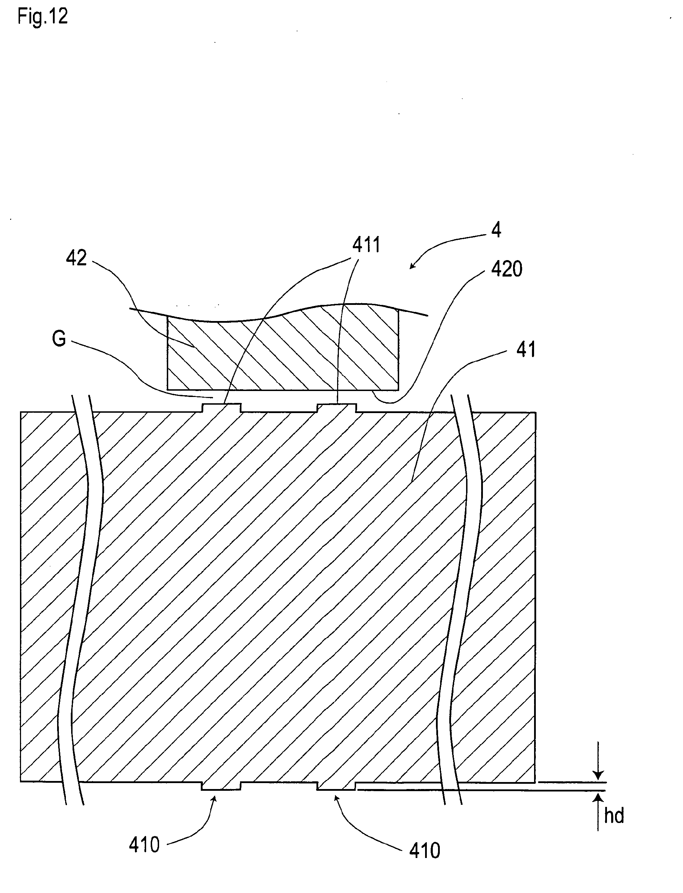

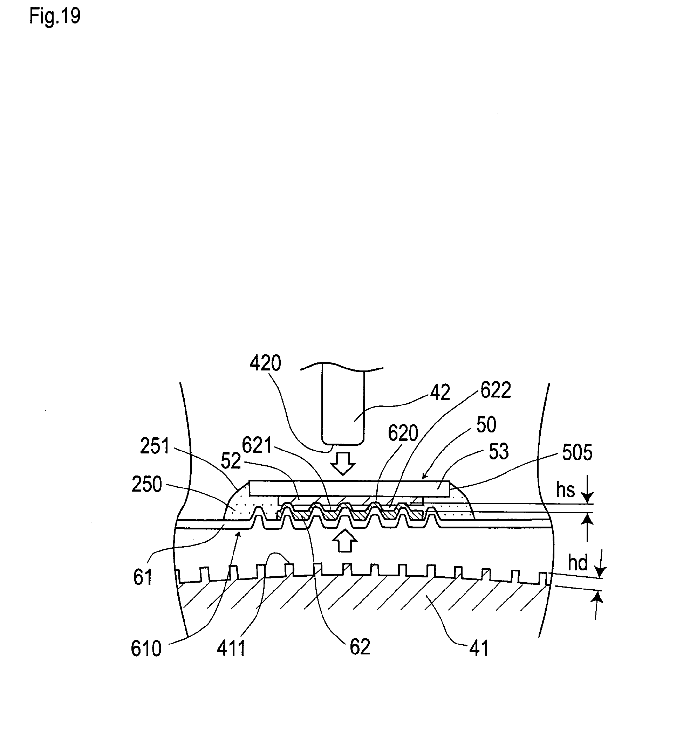

As shown in Figures 11 and 12, the convexity-formed portion 410 is continuously provided with ridge-like protrusions 411 provided in an extending manner to be substantially parallel to the direction of the axis center. Each of the protrusions 411 protrudes toward the peripheral side of the second anvil roller 41. In this embodiment, the formation pitch of the protrusions 411 is set so that several protrusions 411 face each of the base-side terminals 62 (see Figure 19). In this embodiment, the protruding height hd of the protrusion 411 is 400 µm.

Furthermore, the second anvil roller 41 of this embodiment has an unillustrated heater. As shown in Figures 10 to 12, the second anvil roller 41 presses the continuous base member 610 by the protrusion 411 heated by using this heater. Because of this, the continuous base member 610 formed from a thermoplastic material is caused to protrude and deformed easily and with high shape accuracy.

As shown in Figures 11 and 12, the bonding head 42 faces the outermost peripheral surface of the second anvil roller 41 formed by the protruding surface of each protrusion 411 thereof with a gap G of 230 µm as described above. Incidentally, the bonding head 42 has an unillustrated vibration application unit. This vibration application unit configured to apply ultrasonic vibrations to a pressing surface 420 of the bonding head 42.

Incidentally, the pressing surface 420 is subjected to diamond coat treatment, which is surface treatment, in order to suppress the friction with the rear surface of the interposer 50. In place of this treatment, it is also effective to subject the pressing surface 420 to surface treatment, such as Teflon(R) coat, and to dispose a cemented carbide chip made of tungsten carbide on the pressing surface 420. Furthermore, it is also advisable to provide a rotating roller at the leading end of the bonding head 42, whereby the peripheral surface of this rotating roller is used as the pressing surface.

Next, the cutting unit 7 will be described. As shown in Figures 1 and 13, the cutting unit 7 of this embodiment cuts out the RF-ID medium 5 from the continuous base member 610 by a combination of the third anvil roller 71 configured to rotate while holding, on a substantially cylindrical peripheral surface, the continuous base member 610 having the interposer 50 bonded thereto and to advance the continuous base member 610, and the die cut roller 72 that circumscribes the third anvil roller 71 and is provided, on a peripheral surface thereof, with the cutting edge 720.

Next, a description will be given of the procedure for fabricating the RF-ID medium 5 by use of the electronic component manufacturing apparatus 1 constructed as described above. As described above, this electronic circuit manufacturing method includes the interposer cutting-out step of obtaining the interposer 50, the base circuit forming step of forming the base-side terminal 62 on the continuous base member 610, the arranging/bonding step of bonding the interposer 50 to the continuous base member 610, and the separating step of cutting out the RF-ID medium 5 from the continuous base member 610.

Incidentally, in this embodiment, as shown in Figure 1, the above-described manufacturing method was carried out by preparing beforehand the continuous-chip holding member 530 in which the IC chip 51 is continuously mounted on the surface of a resin film in continuous sheet form and which is wound in roll form, and the continuous base member 610 which is wound in roll form.

And in preparing the RF-ID medium 5, the continuous-chip holding member 530 in roll form and the continuous base member 610 in roll form were each set on an unillustrated roll set shaft. The continuous base member 610 has, at an end on the peripheral side of the winding thereof, a leading-end lead on which the antenna pattern 64 is not formed. And in setting the continuous base member 610, as shown in Figure 1, the leading-end lead was wound on the first anvil roller 35 of the converter unit 3 and the second anvil roller 41 of the press unit 4, and the leading end portion of the leading-end lead was caused to be held by the third anvil roller 71 of the cutting unit 7.

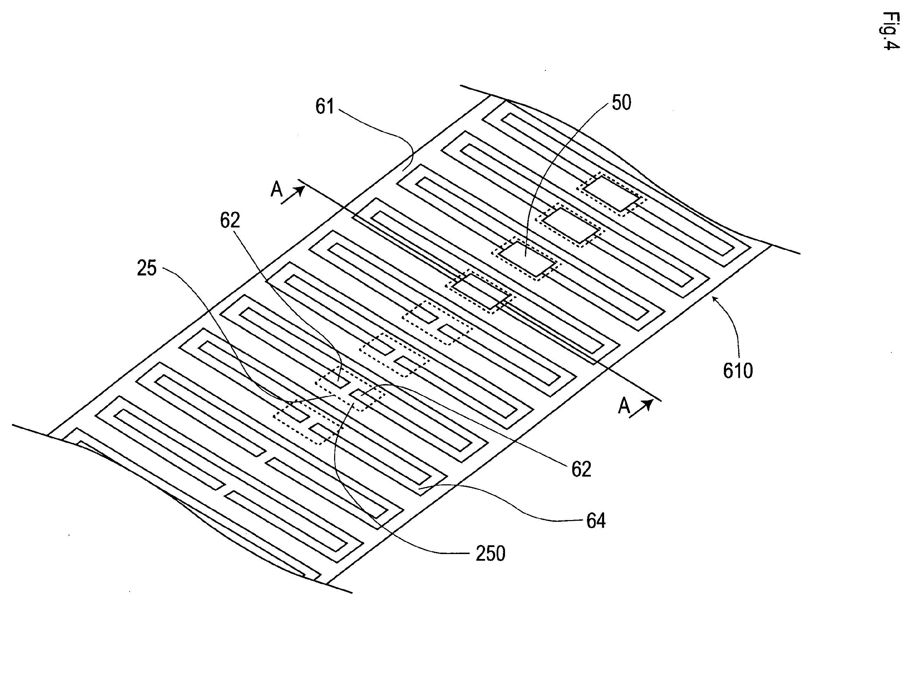

And by rotating the first to third anvil rollers 35,41, 71 in synchronization, the continuous base member 610 is advanced. First, by use of the pattern printing unit 22 arranged on the upstream side of the process of the converter unit 3, as shown in Figures 1 and 4, the antenna pattern 64 was continuously formed on the surface of the continuous base member 610 at substantially constant intervals. After that, by use of an unillustrated adhesive application unit disposed between the converter unit 3 and the pattern printing unit 22, as shown in Figure 4, an adhesive-disposed layer 25 was provided so as to overlap the base-side terminals 62 of the antenna pattern 64 on the surface of the continuous base member 610. Incidentally, in this embodiment, the adhesive-disposed layer 25 was formed by using an insulating adhesive 250 having electrically insulating properties.

In this embodiment, as shown in Figure 4, an adhesive-disposed layer 25 having a thickness of 40 to 80 µm was provided in a region including the interposer-disposed region of the surface of the continuous base member 610. In this embodiment, a thermoplastic, moisture curing hot melt (Model No. TE-031 made by 3M) was used as the insulating adhesive 250.

On the other hand, for the continuous-chip holding member 530, as shown in Figure 14, the interposer cutting-out step is performed by using the interposer cutting-out unit 21. In this interposer cutting-out step, the leading-end portion drawn out of the wound continuous-chip holding member 530 was introduced into the gap between the die cut roller 212 and the rotating roller 211 and the interposer 50 was punched one by one. And the punched interposer 50 in individual-piece form was supplied one by one to the first conveying device 33 of the converter unit 3.

Next, the arranging/bonding step was performed which involves arranging and bonding the interposer 50 one after another in individual-piece form on the surface of the continuous base member 610 in which the adhesive-disposed layer 25 is provided (see Figure 4). In this arranging/bonding step, an interposer arranging step and an interposer pressing step were performed. In the interposer arranging step, the interposer 50 was arranged on the surface of the continuous base material 610 by using the converter unit 3, and in the interposer pressing step, the interposer 50 was bonded under pressure by using the press unit 4.

First, in the interposer arranging step, as shown in Figures 1, 3 and 4, by using the converter unit 3, the interposer 50 in individual-piece form was arranged one by one for each of the antenna patterns 64 of the continuous base material 610. In this embodiment, the interposer 50 was arranged on the surface of the continuous base member 610 so that the base-side terminals 62 of the continuous base member 610 and the interposer-side terminal 52 of the interposer 50 face each other.

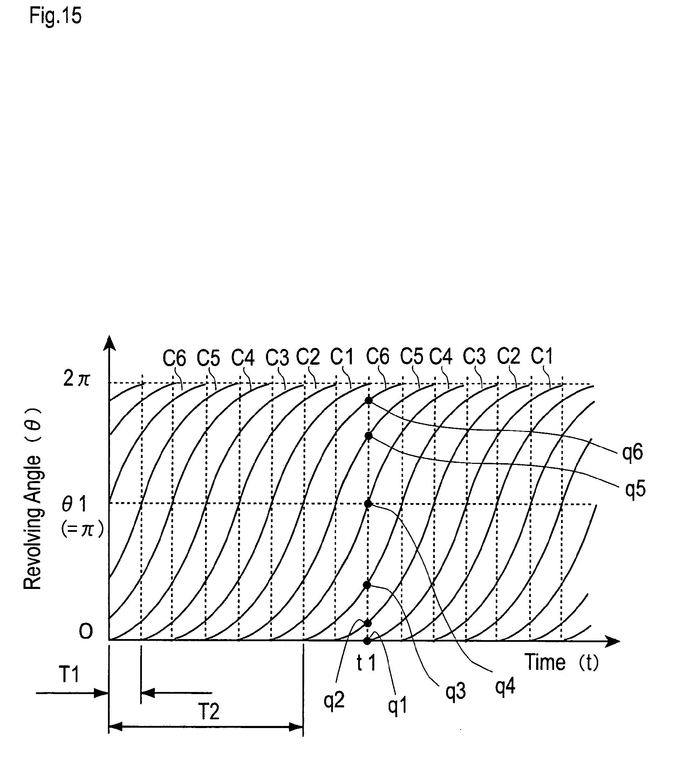

In the converter unit 3, as shown in Figures 9 and 15, each of the end-effectors 371 to 376 performs revolving movement along the same circumference and the cyclic speed change of each of the end-effectors 371 to 376 is independently controlled during the revolving movement including the receipt and delivery of the interposer 50. That is, on the revolving trajectory of the end-effector, timing adjustment for the receipt and delivery of the interposer 50 (revolving position adjustment) and control of the cyclic speed change for adjusting the revolving speed are performed.

For example, the operating condition of the converter unit 3 shown in Figure 3 is such that the end-effector 371 receives the interposer 50 from the first conveying device 33 in the revolving position Q1, whereas the end-effectors 372, 373 are moving in the revolving positions Q2, Q3 toward the first anvil roller 35. The end-effector 374 moving in the revolving position Q4 has arranged the interposer 50 to the continuous base member 610 held by the first anvil roller 35. The end-effectors 375 and 376 are revolving while moving in the revolving positions Q5 and Q6, respectively.

As described above, in the end-effectors 371 to 376 of this embodiment, the suction of the holding surface 370s is controlled. That is, the holding surface 370s is controlled to negative pressure in the revolving zone from the revolving position Q1 to before the revolving position Q4. Because of this, in this revolving zone the interposer 50 is sucked by the holding surface 370s. On the other hand, in the revolving position Q4, the holding surface 370s is controlled to atmospheric pressure. Because of this, when the end-effector 376 has reached the revolving position Q4, the end-effector 376 releases the interposer 50 and smoothly delivers the interposer 50 to the continuous base member 610.

Now the revolving movement of the end-effectors 371 to 376 will be described. Figure 15 shows changes with time in the revolving angles of the end-effectors 371-376. Each of the curves C1 to C6 corresponds to the movement of each of the end-effectors 371 to 376 in Figure 3. The points q1 to q6 at time t1 on the graph in Figure 1 correspond to the revolving positions Q1 to Q6. The position in which the first conveying device 33 and the end unit 36 come into contact with each other (the revolving position Q1) in Figure 3 is regarded as the home position of a revolving angle θ, and the revolving direction is a counterclockwise direction as shown in Figure 3.

The cycle T1 in Figure 15 is a cycle at which the first conveying device 33 supplies the interposer 50 to the end unit 36 (an interposer supply cycle). Incidentally, this interposer supply cycle is determined by the conveying speed of the first conveying device 33 and the interval between the interposers 50 on a conveyor belt 331. The cycle T2 is a cycle at which each of the end-effectors revolves. The relationship T2 ≈ 6 x T1 holds in a short period of time, and the relationship T2 = 6 x T1 holds as a mean in a long period of time. In this embodiment, the six end-effectors 371 to 376 that are independently revolution-controlled are used. Therefore, the end unit 36 of this embodiment is adaptable to an interposer supply speed that is as high as about six times the revolving speed of each end effector.

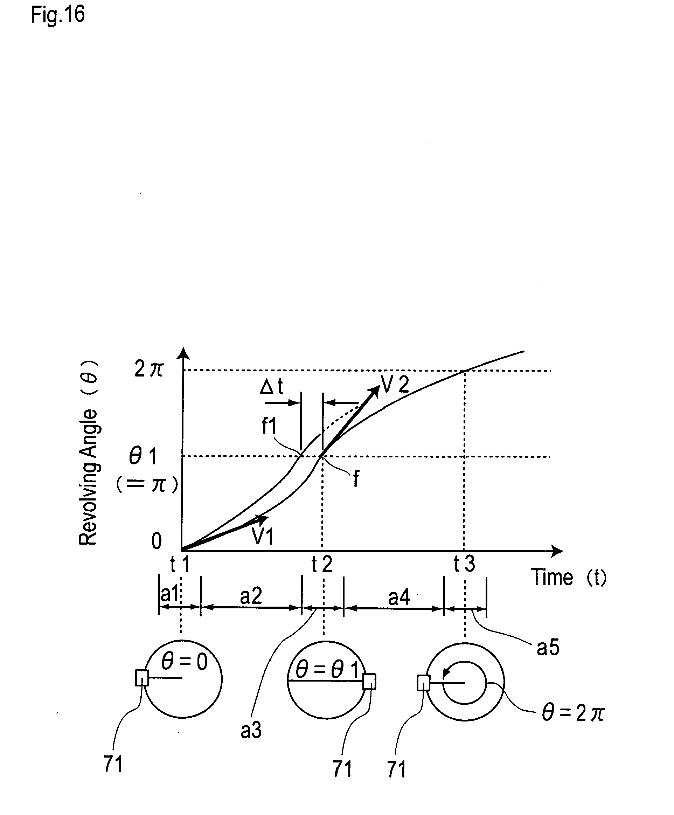

The revolving movement of the end-effector 371, for example, will be described. Figure 16 shows changes with time in the revolving angle of the end-effector 371. When the time t is t1 and the revolving angle 0 is 0, the end-effector 371 receives the interposer 50 from the first conveying device 33 at a speed V1. And when the time t is t2 and the revolving angle 0 is θ1 (= π), the end-effector 371 delivers the interposer 50 to the first anvil roller 35 at a speed V2. After that, when the time t is t3 (= t1 + T2) and the revolving angle is 2π, the end-effector 371 returns to an initial revolving position.

As shown in Figure 16, the time zones al, a3 and a5 are zones in which the end-effector 371 synchronizes with the conveying operation of the first conveying device 33 or the conveying operation of the firs anvil roller 35 in order to receive or deliver the interposer 50. In these time zones, the speed is maintained substantially constant so that the relative speed with respect to the conveying speed of the interposer 50 becomes substantially zero. On the other hand, the time zones a2 and a4 are zones in which the revolving speed of the end-effector 371 is increased or decreased.

In these time zones a2 and a4, the adjustment of the revolving position is performed in addition to the adjustment of the speed. As shown in Figure 16, this revolving position adjustment is performed, for example, when the conveying speed of the first anvil roller 35 has varied. In order to maintain a constant conveying interval when the conveying speed of the first anvil roller 35 has varied, it is necessary to adjust the timing for delivering the interposer 50 from the end unit 36 to the first anvil roller 35. Therefore, in order to adjust this timing, the revolving positions of each of the end-effectors 371 to 376 are controlled.

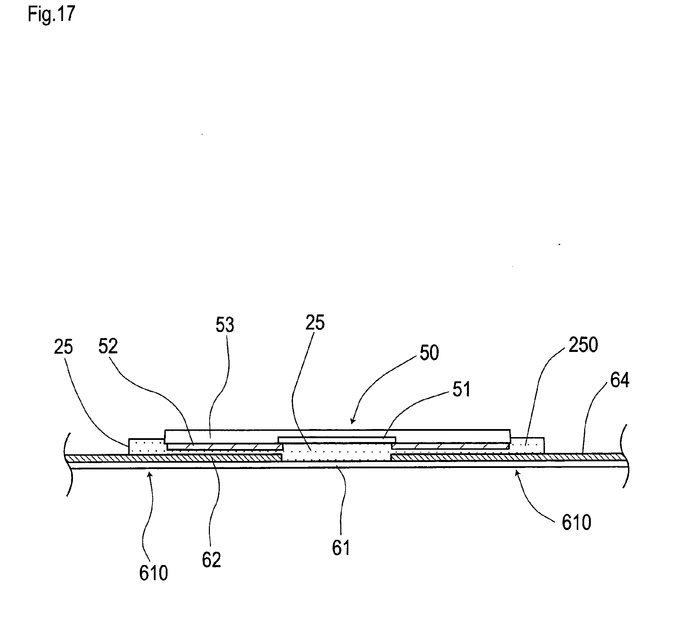

Now it is supposed that as shown in Figure 16, there arises a need to deliver the interposer 50 earlier by a time Δt. In this case, the speed of the end-effector 371 is increased to cause the curve shown in this figure to pass the point fl in place of the point f This allows the interposer 50 to be arranged with good accuracy with respect to the antenna pattern 64 on the continuous base member 610 held by the first anvil roller 35. That is, in this embodiment, as shown in Figures 4 and 17, the interposer 50 was arranged on the surface of the continuous base member 610 so that the base-side terminal 62 of the continuous base member 610 and the interposer-side terminal 52 of the interposer 50 face each other.

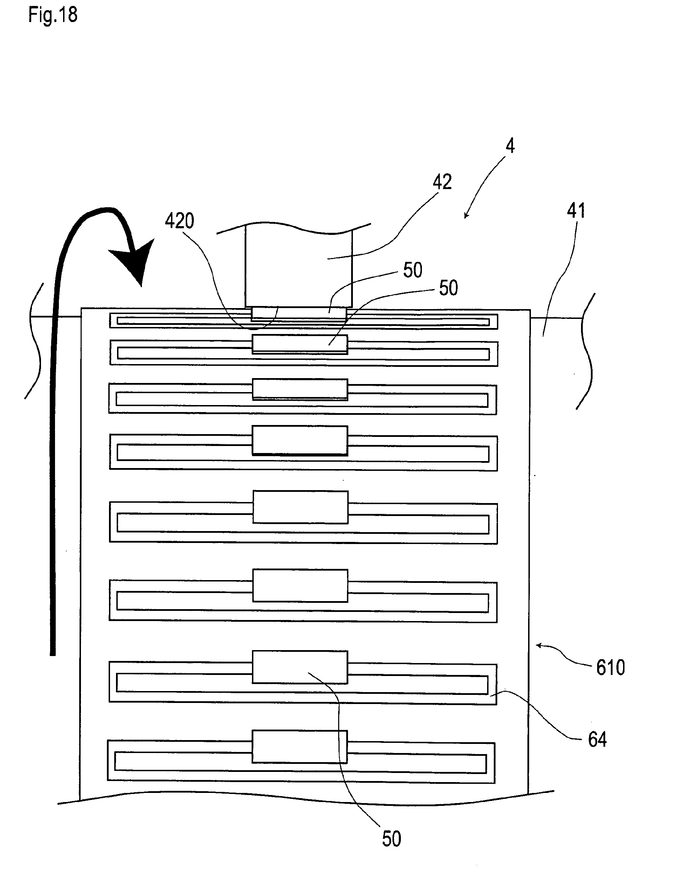

Next, as shown in Figures 18 to 20, the interposer pressing step that makes up the arranging/bonging step was performed. In this embodiment, as described above, the interposer pressing step of pressing the interposer 50 toward a continuous base member 610 was performed by using the press unit 4. As described above, the second anvil roller 41 of the press unit 4 has the protrusions 411 that are provided in ridge form so as to face the rear surface of each of the base-side terminals 62. With the protrusions 411 of this embodiment having a protruding height hd of 400 µm, it is possible to form a protruding deformed portion 620 having a protruding height hs of about 100 µm in the base-side terminal 62. Incidentally, it is advisable that the protruding height hd of the protrusion 411 be 100 to 800 µm.

And in this embodiment, the second anvil roller 41 in which the surface temperature of the pressing surface was maintained at 200°C was rotated and the interposer 50 held by the second anvil roller 41 via the continuous base member 610 was fed one by one under pressure toward the gap G formed by the bonding head 42. As described above, in this embodiment, the gap G between the second anvil roller 41 and the bonding head 42 is set at 230 µm for the combination of the 100 µm thick continuous base member 610 and the 200 µm thick chip holding member 53 that forms the interposer 50. For this reason, when the interpose 50 arranged on the surface of the continuous base member 610 passes the gap G, the interposer 50 can be pressed to the continuous base member 610. The press unit 4 of this embodiment strongly bonds the interposer 50 by using the pressing force generated here.

With the press unit 4 of this embodiment having the combination of the second anvil roller 41 provided with the convexity-formed portion 410 and the bonding head 42, it is possible to cause part of each of the base-side terminals 62 to protrude and be deformed by the protrusion 411. That is, as shown in Figures 19 and 20, it is possible to form the ridge-like protruding deformed portion 620 in each of the base-side terminals 62 so as to correspond to the protrusions 411 provided in ridge form on the pressing surface of the second anvil roller 41. And the base-side terminal 62 and the interposer-side terminal 52 come into direct contact with each other via this ridge-like protruding deformed portion 620, and a gap 622 is formed between the two in portions other than this protruding deformed portion 620.

For this reason, between this protruding deformed portion 620 and the interposer-side terminal 52, as shown in Figures 19 and 20, the insulating adhesive 250 flows out and the protruding deformed portion 620 is pressure bonded to the interposer-side terminal 52. And as a result of this, it is possible to realize electrical connection between the interposer-side terminal 52 and the base-side terminal 62 with high certainty. On the other hand, in the gap 622 between a non-protruding portion 621 except the protruding deformed portion 620 in each of the base-side terminals 62 and the facing interposer-side terminal 52, the insulating adhesive 250 does not flow out completely, and the an appropriate amount of the insulating adhesive 250 remains as it is. Therefore, the adhesive bonding, i.e., physical connection between the interposer-side terminal 52 and the base-side terminal 62 is realized with high certainty via this insulating adhesive 250 remaining in the gap.

Next, the separating step was performed by using the cutting unit 7. In this separating step, as shown in Figures 1 and 13, the continuous base member 610 to which the interposer 50 is bonded was supplied to the gap formed by the third anvil roller 71 and the die cut roller 72. And the RF-ID medium 5 was punched one by one by use of the cutting edge 720 provided on the peripheral surface of the die cut roller 72.

As described above, in the electronic component manufacturing method of this embodiment, the interposer 50 is bonded to a surface of the continuous base member 610 in continuous sheet form. And the RF-ID medium 5 before the dividing into individual pieces was formed on the surface of the continuous base member 610 by this operation. Finally, the RF-ID medium 5 in individual-piece form was punched from the continuous base member 610. According to this manufacturing method, it is possible to continuously fabricate the RF-ID medium 5 with very high production efficiency. Also, because the interposer 50 is continuously bonded to the continuous base member 610, it is possible to maintain the bonding accuracy at high levels and products of excellent quality can be obtained.

In this embodiment, as shown in Figure 4, in bonding the interposer 50 to the continuous base member 610, the adhesive-disposed layer 25 was provided in a region including the region where the interposer 50 is disposed. Because of this, as shown in Figures 19 and 20, the interposer 50 faces the continuous base member 610 via the insulating adhesive 250 over the substantially whole surface of the interposer 50. As a result, the interposer 50 is strongly bonded to the continuous base member 610.

Moreover, in the arranging/bonding step of this embodiment, as shown in Figures 19 and 20, by pressing the interposer 50 to the continuous base member 610, an excess of the insulating adhesive 250 flows behind the peripheral side surface of the interposer 50 and adheres thereto. As a result, an inclined surface 251 formed from the insulating adhesive 250 is formed between the peripheral side surface 505 of the interposer 50 and the surface of the continuous base member 610. Because of this, not only the surface of the interposer 50, but also the peripheral side surface of the interposer 50 becomes adhesive surfaces. Therefore, the interposer 50 becomes bonded very strongly to the continuous base member 710.

Furthermore, in the press unit 4 of this embodiment used in the arranging/bonding step, the second anvil roller 41 that abuts against the continuous base member 610 formed from a thermoplastic material is provided with a heater. For this reason, by performing the interposer pressing step while heating the continuous base member 610 by use of this second anvil roller 41, it is possible to form the protruding deformed portion 620 with good efficiency and with good shape accuracy by using the protrusion 410 of the second anvil roller 41. And it is possible to perform the pressure-bonding of the protruding deformed portion 620 under heat to the interposer-side terminal 52 and electrical connection reliability can be improved.

Moreover, the insulating adhesive 250 used in this embodiment has thermal plasticity. Because of this, the flowability of the insulating adhesive 250 can be increased by heating the insulating adhesive 250 by use of the heater. For this reason, the insulating adhesive 250 is caused to flow from between the protruding deformed portion 620 in the base-side terminal 62 and the interposer-side terminal 52 with high certainty, and it is possible to realize electrical contact between the two with high certainty.

Furthermore, as described above, the press unit 4 is provided with a vibration application unit for applying ultrasonic waves to the bonding head 42. Because of this, in a location where the interposer-side terminal 52 and the base-side terminal 62 come into direct contact with each other, the two can be fusion bonded by ultrasonic wave bonding and the electrical connection reliability can be further improved. By bonding the interposer-side terminal 52 and the base-side terminal 62 by a combination of the pressure-bonding under heat and the fusion bonding by ultrasonic wave bonding, it is possible to maintain the excellent electrical connection condition between the two with high stability in a long period of use of the RF-ID medium 5. Furthermore, the insulating adhesive 250 used in this embodiment is a moisture curing, reactive type. Because of this, after the interposer pressing step is performed, it is possible to bring the bonding condition of the interposer 50 into a state close to perfection, during the storage of the fabricated RD-ID medium 5, for example.

Incidentally, the application of the electronic component manufacturing method and manufacturing apparatus 1 of this embodiment is not limited to the fabrication of the RF-ID medium 5, and the electronic component manufacturing method and manufacturing apparatus 1 of this embodiment are effective also in the fabrication of various kinds of electronic components in which the interposer 50 is used. The electronic component manufacturing method and manufacturing apparatus 1 of this embodiment can be used in the manufacturing process of various electronic components, such as FPCs (flexible printed circuit boards), paper computers and disposable electronic appliances.

Incidentally, the converter unit 3 used in this embodiment can be used not only in the manufacture of RF-ID media, but also in the transfer of electronic components to IC card parts. Furthermore, it is also possible to use devices of substantially the same construction as the converter unit of this embodiment in mounting the IC chip in place of the interposer on the chip holding member. That is, the constitution of the converter unit of this embodiment is applicable to the fabrication process of the interposer. Furthermore, it is also possible to adopt the converter unit of this embodiment as production equipment used in the manufacturing process of sanitary products, such as disposable diapers and hygiene products.

For the shape of the protrusion 411 provided on the pressing surface of the second anvil roller 41 of the press unit 4, it is also possible to adopt a block-like shape, in place of the ridge-like shape of this embodiment. Furthermore, it is possible to form protrusions 411 of various shapes, such as scattered-point-like, cruciform and comb-shaped protrusions. Moreover, for the convexity-formed portion 410, substantially annular protrusions 411 that are provided in an extending manner on the peripheral surface of the second anvil roller 41 in the circumferential direction of the second anvil roller 41 can also be disposed parallel in the direction of the axis center.

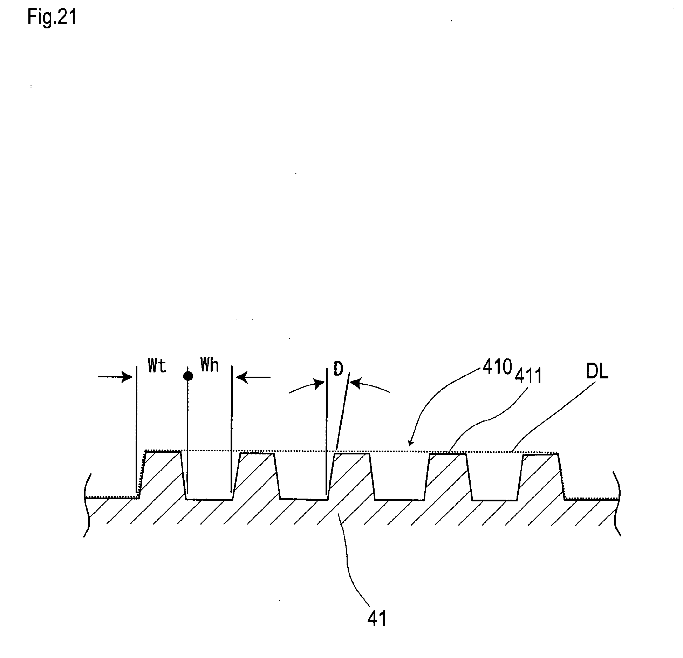

For example, as shown in Figure 21, five block-like protruding shapes arranged at substantially equal intervals on one line can be formed in place of one ridge-like protrusion 411 of this embodiment (the shape indicated by the symbol DL). In this case, these protruding shapes form individual protrusions 411. At this time, for the arrangement shape of the convexity-formed portion 410 formed by all of these protrusions 411, it is possible to adopt substantially the same shape as with the convexity-formed portion 410 of this embodiment (see Figures 11 and 12). Incidentally, as the protruding shape of each of the protrusions 411, it is possible to adopt, for example, a sectional shape that is a square 400 µm (indicated by Wt in the figure) x 400 µm. In the convexity-formed portion 410, it is possible to set the gap Wh between adjacent protrusions 411 at 400 µm. As the protruding inclination angle D of each of the protrusions 411, it is advisable to set 5 degrees to 15 degrees.

Incidentally, in this embodiment, the RF-ID medium 5 as a final product was cut out by using the cutting unit 7. Instead of this, the cutting unit 7 of the electronic component manufacturing apparatus 1 of this embodiment can be replaced with a winding unit that winds the continuous base member 610. In this case, it is possible to fabricate an inlet in roll form, in which the interposer 50 is continuously bonded to the surface of the continuous base member 610, by using this winding unit.

### (Embodiment 2)

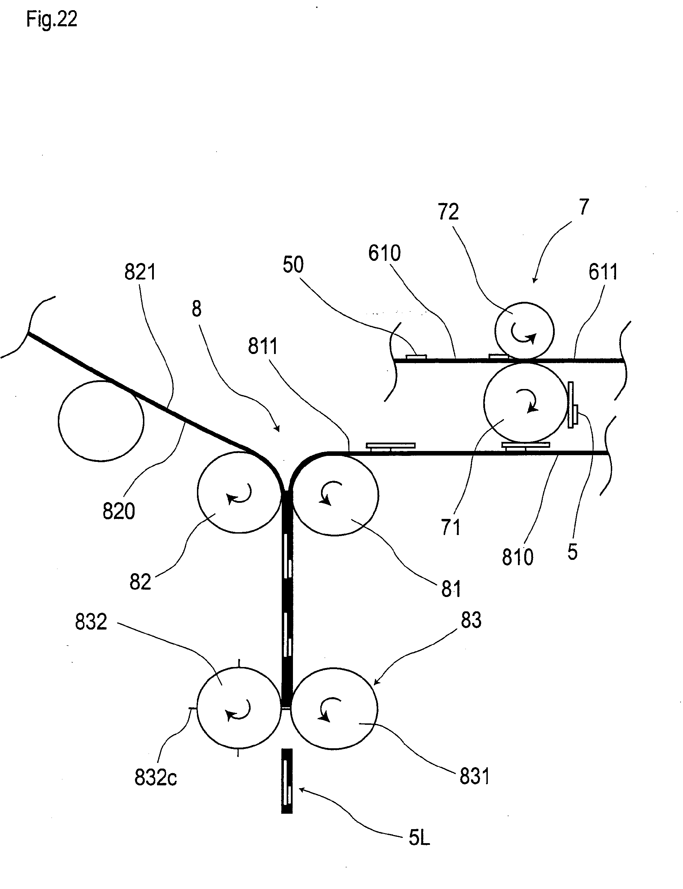

In this embodiment, a laminating step of laminating each RF-ID medium 5 is added on the basis of the electronic component manufacturing method of Embodiment 1. This embodiment will be described with reference to Figure 22.
The electronic manufacturing apparatus 1 of this embodiment has a laminating unit 8 arranged in tandem on the downstream side of the step of the cutting unit 7. This laminating unit 8 laminates each of the RF-ID media 5, which are cut out from a continuous base member 610 by using a cutting unit 7, with resin films 810, 820.

The laminating unit 8 has a rotating roller 81 for holding and advancing the resin film 810 and a rotating roller 82 for holding and advancing the resin film 820. And in this laminating unit 8, the RF-ID medium 5 cut out by the cutting unit 7 is placed one by one on a laminating surface 811 of the resin film 810 held by the rotating roller 81.

The rotating roller 82 and the rotating roller 81 substantially circumscribe each other with an appropriate gap so that the RF-ID medium 5 can be laminated by pressing the resin films 810, 820 that sandwich the RF-ID medium 5. An adhesive is applied beforehand to a lamination surface 821 of the resin film 820 held by the rotating roller 82. For this reason, by causing the resin films 810, 820 that sandwich the RF-ID medium 5 as described above to pass through the gap between the rotating roller 81 and the rotating roller 82, it is possible to obtain a laminated RF-ID medium 5L. Incidentally, instead of this, it is also possible to fusion bond the resin films 810, 820 by heating the bonding surfaces of the resin films 810, 820. It is possible to adopt, for example, a method that involves heating the resin films 810, 820 by using heaters disposed on the rotating rollers 81, 82.

Furthermore, the electronic component manufacturing apparatus 1 of this embodiment is provided with a cutting unit 83 for cutting the resin films 810, 820 in continuous sheet form, which continuously laminate the RF-ID medium 5, for each RF-ID medium 5. This cutting unit 83 is provided with a rotating roller 831 and a die cut roller 832 that circumscribes this rotating roller 831. On the peripheral surface of the die cut roller 832, there are provided a plurality of cutting edges 832c, which are provided in an extending manner in the direction substantially parallel to the axis of rotation. The cutting edges 832c are provided in the circumferential direction of the die cut roller 832 at substantially equal intervals, and the disposition spacing (the circumferential distance) is substantially equal to the width of the laminated medium 5L, which is the laminated RF-ID medium 5.
Incidentally, other constituent features and operation and effect of this embodiment are the same as in Embodiment 1.

## Claims

1. An electronic component manufacturing method for manufacturing an electronic component in which an interposer is bonded to a base circuit sheet, the interposer having a semiconductor chip mounted on a sheet-like chip holding member and having an interposer-side terminal as a connection terminal extending from the semiconductor chip, the base circuit sheet formed from a sheet-like base member and provided with a base-side terminal on a surface thereof, the method comprising:
a base circuit forming step of forming the base-side terminal in a continuous base member that is the base member in continuous sheet form;
an arranging/bonding step of arranging the interposer on a surface of the continuous base member on which the base-side terminal is formed, with the interposer-side terminal and the base-side terminal facing each other, and bonding the interposer; and
a separating step of cutting out the electronic component from the continuous base member to which the interposer is bonded,
wherein, for the common continuous base member, each of the steps is repeated in parallel while the continuous base material is being advanced.

2. The electronic component manufacturing method according to claim 1, wherein in the arranging/bonding step, by use of a converter unit having a first anvil roller configured to rotate while holding the continuous base member on a substantially cylindrical peripheral surface and to advance the continuous base member, and an end-effector configured to hold and revolve the interposer along a substantially circumscribed circle with the peripheral surface of the first anvil roller,
the interposer is arranged on the surface of the continuous base member while the end-effector is being operated so that the relative speed of the interposer becomes substantially zero with respect to the base-side terminal of the continuous base member held by the first anvil roller in a rotating condition.

3. The electronic component manufacturing method according to claim 2, wherein the arranging/bonding step uses a press unit having a second anvil roller that rotates while holding the continuous base member on a substantially cylindrical peripheral surface, and a bonding head that faces a peripheral surface of the second anvil roller with a prescribed gap and to press and bond the interposer on the continuous base member, and
in response to the second anvil roller being rotated, the interposer arranged on the continuous base member, along with the continuous base member, is fed under pressure into the prescribed gap and the interposer is bonded under pressure to the continuous base member.

4. The electronic component manufacturing method according to claim 3, wherein the continuous base member is formed from a plastic material, and the second anvil roller is provided, on the peripheral surface thereof, with a convexity-formed portion including protrusions that protrude so as to face part of the base-side terminal, and
in the arranging/bonding step, with an insulating adhesive having electrical insulating properties disposed at least between the base-side terminal and the interposer-side terminal, the continuous base member and the interposer is fed into the prescribed gap and the part of the base-side terminal is caused to protrude and deformed by the protrusion, whereby the part of the base-side terminal is caused to abut against the interposer-side terminal.

5. The electronic component manufacturing method according to any one of claims 1 to 4, wherein the semiconductor chip is an IC chip for RF-ID media and the base circuit sheet is provided with an antenna pattern to be electrically connected to the IC chip.

6. An electronic component manufacturing apparatus for fabricating an electronic component in which an interposer is bonded to a base circuit sheet, the interposer having a semiconductor chip mounted on a sheet-like chip holding member and having an interposer-side terminal as a connection terminal extending from the semiconductor chip, the base circuit sheet formed from a sheet-like base member and provided with a base-side terminal on a surface thereof, the electronic component manufacturing apparatus comprising:
a converter unit having a first anvil roller configured to rotate while holding, on a substantially cylindrical peripheral surface, a continuous base member that is the base member in continuous sheet form having the base-side terminal continuously provided on the surface thereof and to advance the continuous base member, and an end-effector configured to hold and revolve the interposer along a substantially circumscribed circle with the peripheral surface of the first anvil roller, and to arrange the interposer sequentially on the surface of the continuous base member so that the base-side terminal of the continuous base member and the interposer-side terminal face each other;
a press unit having a second anvil roller configured to rotate while holding, on a substantially cylindrical peripheral surface, the continuous base member having the interposer arranged thereon and to advance the continuous base member, and a bonding head configured to face a peripheral surface of the second anvil roller with a prescribed gap and to press and bond the interposer, which has been fed under pressure into the prescribed gap, on the continuous base member; and
a cutting unit configured to cut out the electronic component from the continuous base member by a combination of a third anvil roller configured to rotate while holding the continuous base member having the interposer bonded thereon on a substantially cylindrical peripheral surface and to advance the continuous base member, and a die cut roller that circumscribes the third anvil roller via the continuous base member and is provided, on a peripheral surface thereof, with a cutting edge.

7. The electronic component manufacturing apparatus according to claim 6, wherein the converter unit is configured to arrange the interposer on the surface of the continuous base member while the end-effector is being operated so that the relative speed of the interposer becomes substantially zero with respect to the base-side terminal of the continuous base member held by the first anvil roller when rotating.

8. The electronic component manufacturing apparatus according to claim 6, wherein the continuous base member is formed from a plastic resin material and the second anvil roller is provided, on the peripheral surface thereof, with a convexity-formed portion including protrusions that protrude toward part of a rear surface region of the base-side terminal provided in the continuous base member.

9. The electronic component manufacturing apparatus according to claim 8, wherein the apparatus is configured to bond the interposer to the continuous base member with an adhesive disposed at least in the gap between the interposer-side terminal and the base-side terminal within the gap formed by the interposer and the continuous base member by facing each other, and
wherein the adhesive is an insulating adhesive having electrical insulating properties.

10. The electronic component manufacturing apparatus according to claim 9, wherein the press unit is configured to apply ultrasonic vibrations to a location where the interposer and the continuous base member abut each other.

11. The electronic component manufacturing apparatus according to claim 8, wherein the second anvil roller has the convexity-formed portion provided in an extending manner along the whole circumference of the peripheral surface thereof

12. The electronic component manufacturing apparatus according to claim 11, wherein
the interposer has a pair of the interposer-side terminals arranged opposite to each other, with the semiconductor chip interposed therebetween, and
wherein the second anvil roller has two convexity-formed portions spaced along a rotating axis thereof and the second anvil roller is configured to hold the continuous base member with each of the convexity-formed portions facing different base-side terminals.

13. The electronic component manufacturing apparatus according to claim 6, wherein the apparatus is provided with an interposer cutting-out unit configured to cut out the interposer from a continuous-chip holding member one by one, the chip holding member provided in continuous sheet form on which the semiconductor chip is mounted, and
wherein the converter unit is configured to receive the interposer from the interposer cutting-out unit.

14. The electronic component manufacturing apparatus according to any one of claims 6 to 13,
wherein the semiconductor chip is an IC chip for RF-ID media and the base circuit sheet is provided with an antenna pattern to be electrically connected to the IC chip.
